# EUROPEAN PATENT APPLICATION

(11) **EP 4 586 784 A1**
(43) Date of publication of application: **16.07.2025**
(21) Application number: 23954573.4
(22) Date of filing: 27.11.2023
(51) Int. Cl.: H10K 59/131, H10K 59/123, H10K 59/12

(54) **DISPLAY PANEL AND DISPLAY APPARATUS**

(71) Applicant: BOE TECHNOLOGY GROUP CO., LTD., Beijing 100015 (CN); Chengdu BOE Optoelectronics Technology Co., Ltd., Chengdu, Sichuan 611731 (CN)
(72) Inventor: ZHANG, Bo, Beijing 100176 (CN); QU, Yi, Beijing 100176 (CN); LUO, Min, Beijing 100176 (CN); FENG, Aoyuan, Beijing 100176 (CN); LI, Bin, Beijing 100176 (CN)
(74) Representative: Durán-Corretjer, S.L.P.
(86) International application number: PCT/CN2023/134318
(87) International publication number: WO 2025/111740

(57) **Abstract**

A display panel includes a base substrate (10), a display structure layer, and a touch structure layer (15). The base substrate (10) includes a display region (AA), a second bezel region (B2) located on a side of the display region (AA), and a first bezel region (B1) located on remaining sides of the display region (AA). The display structure layer includes at least one first crack detection line (311) and a plurality of data leading-out lines (323). The touch structure layer (15) includes at least one second crack detection line (312). The first crack detection line (311) and the second crack detection line (312) are connected in series in the second bezel region (B2) through a plurality of detection connection lines (321, 322a, 322b). An orthographic projection of at least one detection connection line (321) on the base substrate (10) is overlapped with an orthographic projection of at least one data leading-out line (323) on the base substrate (10), and at least two insulation layers are provided between at least a part of line segments of at least one detection connection line (321) and at least one data leading-out line (323).

## Description

### Technical Field

The present disclosure relates to, but is not limited to, the field of display technologies, in particular to a display panel and a display apparatus.

### Background

An Organic light emitting Diode (OLED) is an active light emitting display device and has advantages such as self-luminescence, a wide viewing angle, a high contrast ratio, low power consumption, an extremely high response speed, etc. With continuous development of display technologies, a display apparatus using an OLED as a light emitting device and a Thin Film Transistor (TFT) for signal control has become a mainstream product in the field of display at present.

### Summary

The following is a summary of subject matters described herein in detail. This summary is not intended to limit the protection scope of claims.

Embodiments of the present disclosure provide a display panel and a display apparatus.

In one aspect, an embodiment provides a display panel including a base substrate, a display structure layer, and a touch structure layer which are disposed on the base substrate. The base substrate includes a display region and a bezel region located at a periphery of the display region. The bezel region includes a second bezel region located on a side of the display region, and a first bezel region located on remaining sides of the display region. The display structure layer includes a plurality of sub-pixels and a plurality of data lines located in the display region, at least one first crack detection line located in the first bezel region, and a plurality of data leading-out lines located in the second bezel region. The plurality of data lines are connected with the plurality of sub-pixels and are configured to provide data signals to the plurality of sub-pixels. The plurality of data leading-out lines are configured to provide data signals to the plurality of data lines. The touch structure layer is located on a side of the display structure layer away from the base substrate. The touch structure layer includes at least one second crack detection line located in the first bezel region. At least one first crack detection line and at least one second crack detection line are connected in series in the second bezel region through a plurality of detection connection lines. An orthographic projection of at least one of the plurality of detection connection lines on the base substrate is overlapped with an orthographic projection of at least one of the plurality of data leading-out lines on the base substrate, and at least two insulation layers are provided between at least a part of line segments of the at least one detection connection line and the at least one data leading-out line.

In some exemplary implementation modes, the at least two insulation layers may include at least one organic insulation layer and at least one inorganic insulation layer.

In some exemplary implementation modes, a minimum thickness between at least a part of line segments of the at least one detection connection line and the at least one data leading-out line is greater than 2.1 microns.

In some exemplary implementation modes, the display panel further includes at least one shielding electrode located in the second bezel region. In a direction perpendicular to the display panel, the shielding electrode is located between at least a part of line segments of the at least one detection connection line and the at least one data leading-out line; and an orthographic projection of the shielding electrode on the base substrate covers an overlapping portion of an orthographic projection of the at least one detection connection line on the base substrate and the orthographic projection of the at least one data leading-out line on the base substrate.

In some exemplary implementation modes, the display panel further includes a plurality of first power lines located in the display region and a first electrical power supply line located in the second bezel region, wherein the plurality of first power lines are electrically connected with the plurality of sub-pixels and the plurality of first power lines are connected with the first electrical power supply line, and the at least one shielding electrode is connected with the first electrical power supply line.

In some exemplary implementation modes, the first electrical power supply line includes a first sub-electrical power supply line and a second sub-electrical power supply line connected with each other, and the first sub-electrical power supply line is located on a side of the second sub-electrical power supply line close to the base substrate; and the at least one shielding electrode and the first sub-electrical power supply line are of an interconnected integral structure.

In some exemplary implementation modes, at least a part of line segments of the at least one detection connection line and the second sub-electrical power supply line are of a same layer structure.

In some exemplary implementation modes, the first electrical power supply line includes a first sub-electrical power supply line and a second sub-electrical power supply line connected with each other, and the first sub-electrical power supply line is located on a side of the second sub-electrical power supply line close to the base substrate; the at least one shielding electrode and the second sub-electrical power supply line are of an interconnected integral structure; and at least a part of line segments of the at least one detection connection line is located on a side of the second sub-electrical power supply line away from the base substrate.

In some exemplary implementation modes, the display structure layer at least includes: a first gate metal layer, a second gate metal layer, a first source-drain metal layer, and a second source-drain metal layer which are disposed on the base substrate; and an interlayer dielectric layer is provided between the second gate metal layer and the first source-drain metal layer, and at least a first planarization layer is provided between the first source-drain metal layer and the second source-drain metal layer. At least a part of line segments of the at least one detection connection line is located in the second source-drain metal layer, and the shielding electrode is located in the first source-drain metal layer. The insulation layer between at least a part of line segments of the at least one detection connection line and the at least one data leading-out line at least includes an interlayer dielectric layer and a first planarization layer.

In some exemplary implementation modes, the plurality of data leading-out lines include a plurality of first data leading-out lines located in the first gate metal layer and a plurality of second data leading-out lines located in the second gate metal layer, and the plurality of first data leading-out lines and the plurality of second data leading-out lines are alternately disposed.

In some exemplary implementation modes, the touch structure layer includes at least one touch conductive layer, and at least a part of line segments of the at least one detection connection line is located in a touch conductive layer of the touch structure layer.

In some exemplary implementation modes, the second bezel region includes a first signal access region, the first signal access region includes a plurality of data contact pads, at least one first detection contact pad, and at least one second detection contact pad, and the at least one first detection contact pad and at least one second detection contact pad are located on both sides of the plurality of data contact pads along a first direction; and the plurality of data contact pads are connected with the plurality of data leading-out lines. The plurality of detection connection lines include: two second detection connection lines and at least one first detection connection line; the first detection connection line is connected in series with the first crack detection line and the second crack detection line; and one end of the first crack detection line and the second crack detection line connected in series is connected with the at least one first detection contact pad through one second detection connection line, and the other end is connected with the at least one second detection contact pad through the other second detection connection line. An orthographic projection of a part of line segments of the at least one first detection connection line on the base substrate is partially overlapped with an orthographic projection of the at least one data leading-out line on the base substrate.

In some exemplary implementation modes, in the two second detection connection lines, an orthographic projection of one second detection connection line on the base substrate is partially overlapped with the orthographic projection of the at least one data leading-out line on the base substrate; and a distance between an orthographic projection of the other second detection connection line on the base substrate and orthographic projections of the plurality of data leading-out lines on the base substrate is greater than 0.

In some exemplary implementation modes, a part of line segments of the first detection connection line whose orthographic projection is overlapped with an orthographic projection of the at least one data leading-out line on the base substrate, and a part of line segments of the second detection connection line whose orthographic projection is overlapped with the orthographic projection of the at least one data leading-out line on the base substrate are of a same layer structure.

In some exemplary implementation modes, a distance between orthographic projections of the two second detection connection lines on the base substrate and orthographic projections of the plurality of data leading-out lines on the base substrate is greater than 0.

In some exemplary implementation modes, the at least one first detection connection line includes a first extension segment, a second extension segment, and a third extension segment connected in sequence, wherein an extension direction of the second extension segment intersects with an extension direction of the first extension segment and an extension direction of the third extension segment, an orthographic projection of the second extension segment is partially overlapped with the orthographic projection of the at least one data leading-out line on the base substrate, and a distance between orthographic projections of the first extension segment and the third extension segment on the base substrate and orthographic projections of the plurality of data leading-out lines on the base substrate is greater than 0.

In some exemplary implementation modes, the second extension segment is located on a side of the first extension segment and the third extension segment away from the base substrate, and the second extension segment is connected with the first extension segment or the third extension segment through a second connection electrode.

In some exemplary implementation modes, the first extension segment, the second extension segment, and the third extension segment of the first detection connection line are of an interconnected integral structure.

In some exemplary implementation modes, the display structure layer includes a plurality of first crack detection lines, the plurality of first crack detection lines are disposed symmetrically with respect to a centerline of the display panel in a first direction. The touch structure layer includes a plurality of second crack detection lines, and the plurality of second crack detection lines are symmetrically disposed with respect to the centerline of the display panel in the first direction.

In some exemplary implementation modes, an orthographic projection of each data leading-out line located in the second bezel region on the base substrate is overlapped with orthographic projections of a same number of detection connection lines on the base substrate.

In some exemplary implementation modes, a plurality of detection connection lines of the second bezel region are symmetrically disposed with respect to the centerline of the display panel in the first direction.

In some exemplary implementation modes, the second bezel region further includes a bending region, the bending region includes a plurality of detection bending lines, and the plurality of detection connection lines are connected with the at least one first crack detection line and the at least one second crack detection line through the plurality of detection bending lines; and the plurality of detection bending lines are of a same layer structure.

In another aspect, an embodiment provides a display apparatus, including the aforementioned display panel.

In another aspect, an embodiment provides a display panel, including a base substrate, and a display structure layer, a touch structure layer, and at least one shielding electrode which are disposed on the base substrate. The base substrate includes: a display region and a bezel region located at a periphery of the display region, and the bezel region includes: a second bezel region located on a side of the display region, and a first bezel region located on remaining sides of the display region. The display structure layer includes a plurality of sub-pixels and a plurality of data lines located in the display region, at least one first crack detection line located in the first bezel region, and a plurality of data leading-out lines located in the second bezel region. The plurality of data lines are connected with the plurality of sub-pixels and are configured to provide data signals to the plurality of sub-pixels. The plurality of data leading-out lines are configured to provide data signals to the plurality of data lines. The touch structure layer is located on a side of the display structure layer away from the base substrate, and the touch structure layer includes at least one second crack detection line located in the first bezel region; and the at least one first crack detection line and the at least one second crack detection line are connected in series in the second bezel region through a plurality of detection connection lines. An orthographic projection of at least one of the plurality of detection connection lines on the base substrate is overlapped with an orthographic projection of at least one of the plurality of data leading-out lines on the base substrate. The at least one shielding electrode is located in the second bezel region. In a direction perpendicular to the display panel, the shielding electrode is located between at least a part of line segments of the at least one detection connection line and the at least one data leading-out line, and an orthographic projection of the shielding electrode on the base substrate is at least partially overlapped with orthographic projections of the at least one detection connection line and the at least one data leading-out line on the base substrate.

In some exemplary implementation modes, at least two insulation layers are provided between at least a part of line segments of the at least one detection connection line and the at least one data leading-out line, and the at least two insulation layers include at least one organic insulation layer and at least one inorganic insulation layer.

In some exemplary implementation modes, a minimum thickness between at least a part of line segments of the at least one detection connection line and the at least one data leading-out line is greater than 2.1 microns.

In some exemplary implementation modes, the display panel further includes a plurality of first power lines located in the display region and a first electrical power supply line located in the second bezel region, wherein the plurality of first power lines are electrically connected with the plurality of sub-pixels and the plurality of first power lines are connected with the first electrical power supply line, and the at least one shielding electrode is connected with the first electrical power supply line.

In some exemplary implementation modes, the first electrical power supply line includes a first sub-electrical power supply line and a second sub-electrical power supply line connected with each other, and the first sub-electrical power supply line is located on a side of the second sub-electrical power supply line close to the base substrate; and the at least one shielding electrode and the first sub-electrical power supply line are of an interconnected integral structure, or the at least one shielding electrode and the second sub-electrical power supply line are of an interconnected integral structure.

In some exemplary implementation modes, the touch structure layer includes at least one touch conductive layer, and at least a part of line segments of the at least one detection connection line is located in a touch conductive layer of the touch structure layer.

Other aspects may be comprehended after drawings and detailed description are read and understood.

### Brief Description of Drawings

Accompanying drawings are used for providing further understanding of technical solutions of the present disclosure, constitute a portion of the specification, and are used for explaining the technical solutions of the present disclosure together with the embodiments of the present disclosure, but do not constitute limitations on the technical solutions of the present disclosure.
FIG. 1 is a schematic diagram of a display panel according to at least one embodiment of the present disclosure.
FIG. 2 is a schematic partial cross-sectional view of a display region of a display panel according to at least one embodiment of the present disclosure.
FIG. 3 is a schematic diagram of crack detection of a display panel according to at least one embodiment of the present disclosure.
FIG. 4 is a partial schematic diagram of a second bezel region of a display panel according to at least one embodiment of the present disclosure.
FIG. 5 is a schematic diagram of an arrangement of traces of a bending region of a second bezel region according to at least one embodiment of the present disclosure.
FIG. 6 is a partially enlarged view of a region C1 in FIG. 4.
FIG. 7A is a schematic partial cross-sectional view along a direction Q1-Q1' in FIG. 6.
FIG. 7B is another schematic partial cross-sectional view along a Q1-Q1' direction in FIG. 6.
FIG. 8 is a partial schematic diagram of a second bezel region according to at least one embodiment of the present disclosure.
FIG. 9 is a partially enlarged schematic view of a first transfer region D1 in FIG. 8.
FIG. 10 is a schematic partial cross-sectional view along a direction Q2-Q2' in FIG. 9.
FIG. 11 is a partially enlarged schematic view of a second transfer region D2 in FIG. 8.
FIG. 12 is a schematic partial cross-sectional view along a direction Q3-Q3' in FIG. 11.
FIG. 13 is a partially enlarged schematic view of a third transfer region D3 in FIG. 8.
FIG. 14 is a schematic partial cross-sectional view along a direction Q4-Q4' in FIG. 13.
FIG. 15 is a partial schematic diagram of a second bezel region according to at least one embodiment of the present disclosure.
FIG. 16 is a partially enlarged schematic view of a region C2 in FIG. 15.
FIG. 17A is a schematic partial cross-sectional view along a direction Q5-Q5' in FIG. 16.
FIG. 17B is another schematic partial cross-sectional view along a Q5-Q5' direction in FIG. 16.
FIG. 17C is another schematic partial cross-sectional view along a Q5-Q5' direction in FIG. 16.
FIG. 18 is a partially enlarged schematic view of an eighth transfer region D8 in FIG. 15.
FIG. 19 is a schematic partial cross-sectional view along a direction Q6-Q6' in FIG. 18.
FIG. 20 is a partially enlarged schematic view of a tenth transfer region D10 in FIG. 15.
FIG. 21 is a schematic partial cross-sectional view along a direction Q7-Q7' in FIG. 20.
FIG. 22 is another partial schematic diagram of a second bezel region according to at least one embodiment of the present disclosure.
FIG. 23 is a partially enlarged schematic view of a region C3 in FIG. 22.
FIG. 24 is a schematic partial cross-sectional view along a direction Q8-Q8' in FIG. 23.
FIG. 25 is another partial schematic diagram of a second bezel region according to at least one embodiment of the present disclosure.
FIG. 26 is a partially enlarged schematic view of a region C4 in FIG. 25.
FIG. 27 is a schematic partial cross-sectional view along a direction Q9-Q9' in FIG. 26.
FIG. 28 is another schematic diagram of crack detection of a display panel according to at least one embodiment of the present disclosure.
FIG. 29 is a partially enlarged schematic view of a second bezel region in FIG. 28.
FIG. 30 is a schematic diagram of a structure of a partial film layer of a region C5 in FIG. 29.
FIG. 31 is a schematic diagram of a display apparatus according to at least one embodiment of the present disclosure.

### Detailed Description

The embodiments of the present disclosure will be described below with reference to the drawings in detail. Implementation modes may be implemented in a plurality of different forms. Those of ordinary skills in the art may easily understand such a fact that modes and contents may be transformed into other forms without departing from the purpose and scope of the present disclosure. Therefore, the present disclosure should not be explained as being limited to the contents recorded in the following implementation modes only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the accompanying drawings schematically illustrate ideal examples, and one mode of the present disclosure is not limited to shapes, numerical values, or the like shown in the drawings.

Ordinal numerals "first", "second", "third", etc., in the specification are set not to form limits in numbers but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements with reference to the drawings, not to indicate or imply that involved apparatuses or elements are required to have specific orientations and be structured and operated with the specific orientations but only to easily and simply describe the specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined explicitly, terms "mount", "mutually connect", "connect", and "couple" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art may understand meanings of the aforementioned terms in the present disclosure according to situations.

In the specification, an "electrical connection" includes a connection of constituent elements through an element with a certain electrical action. The "element with a certain electrical action" is not particularly limited as long as electrical signals between the connected constituent elements may be transmitted. Examples of the "element with a certain electrical action" not only include an electrode and a wiring, but also include a switching element such as a transistor, a resistor, an inductor, a capacitor, another element with a plurality of functions, etc.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. In the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification. In addition, a gate may also be referred to as a control electrode.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In this specification, a circle, oval, triangle, rectangle, trapezoid, pentagon, or hexagon, etc. is not strictly speaking, but may be an approximate circle, oval, triangle, rectangle, trapezoid, pentagon, or hexagon, etc. Some small deformations due to tolerances may exist, for example, guide angles, curved edges, and deformations thereof may exist.

In the present disclosure, "about" and "substantially" refer to that a boundary is not defined strictly and a case within a range of process and measurement errors is allowed. In the present disclosure, "same" includes completely same and substantially same cases, and "substantially the same" refers to a case where an exponential value differs by less than 10%.

In the present specification, "A extends along a B direction" means that A may include a main portion and a secondary portion connected with the main portion, the main portion is a line, a line segment, or a strip-shaped body, the main portion extends along the B direction, and a length of the main portion extending along the B direction is greater than a length of the secondary portion extending along another direction. "A extends in a B direction" in the present specification always means "a main portion of A extends in a B direction".

In the specification, "A and B are of a same layer structure" and "A and B are disposed in a same layer" means that A and B are formed simultaneously through a same patterning process or that distances between surfaces of A and B close to a base substrate are substantially the same, or that the surfaces of A and B close to the base substrate are in direct contact with a same film layer. A "same layer" does not always mean that thicknesses of layers or heights of layers are the same in a section diagram. A "thickness" of a film layer is a dimension of the film layer in a direction perpendicular to the display substrate. "An orthographic projection of A contains an orthographic projection of B" means that the orthographic projection of B falls within a range of the orthographic projection of A, or the orthographic projection of A covers the orthographic projection of B.

In the display industry, with continuous development of technologies, there is an increasing demand for display products (such as wearable display products), and requirements for screen image quality are becoming more and more stringent, especially low-grayscale image quality, which has become a current main direction of improving image quality. For small display products taking wearable products as an example, due to their relatively small sizes, data signals of the display products are easily disturbed by parasitic capacitors, thereby affecting display quality.

The embodiment provides a display panel and a display apparatus, which may reduce interference of a parasitic capacitor on a data signal, thereby improving display quality of the display panel, and reducing a risk of poor display of the display panel.

An embodiment provides a display panel including a base substrate, and a display structure layer and a touch structure layer which are disposed on the base substrate. The base substrate includes a display region and a bezel region located at a periphery of the display region. The bezel region includes a second bezel region located on a side of the display region, and a first bezel region located on remaining sides of the display region. The display structure layer includes a plurality of sub-pixels and a plurality of data lines located in the display region, at least one first crack detection line located in the first bezel region, and a plurality of data leading-out lines located in the second bezel region. The plurality of data lines are connected with the plurality of sub-pixels and are configured to provide data signals to the plurality of sub-pixels. The plurality of data leading-out lines are configured to provide data signals to the plurality of data lines. The touch structure layer is located on a side of the display structure layer away from the base substrate. The touch structure layer includes at least one second crack detection line located in the first bezel region. At least one first crack detection line and at least one second crack detection line are connected in series in the second bezel region through a plurality of detection connection lines. An orthographic projection of at least one of the plurality of detection connection lines on the base substrate is overlapped with an orthographic projection of at least one of the plurality of data leading-out lines on the base substrate, and at least two insulation layers are provided between at least a part of line segments of the at least one detection connection line and the at least one data leading-out line. In some examples, the at least two insulation layers may include at least one organic insulation layer and at least one inorganic insulation layer. For example, one organic insulation layer and two inorganic insulation layers may be provided between at least a part of line segments of at least one detection connection line and at least one data leading-out line, or two organic insulation layers and three or more inorganic insulation layers may be provided.

In the display panel according to the present embodiment, at least two insulation layers are disposed between at least a part of line segments of a detection connection line and a data leading-out line of which an orthographic projection is overlapped with an orthographic projection of the detection connection line, which may increase a distance between the detection connection line and the data leading-out line of which the orthographic projection is overlapped with the orthographic projection of the detection connection line, thereby reducing a coupling capacitance between the detection connection line and the data leading-out line, reducing interference of the coupling capacitance on a data signal, thus improving display quality of the display panel, and reducing a risk of poor display of the display panel.

In some exemplary implementation modes, a minimum thickness between at least a part of line segments of the at least one detection connection line and the at least one data leading-out line may be greater than 2.1 microns. In this example, by setting the distance between the detection connection line and the data leading-out line of which the orthographic projection is overlapped with the orthographic projection of the detection connection line, the coupling capacitance between the detection connection line and the data leading-out line may be reduced, and the interference of the coupling capacitance on the data signal may be reduced.

In some exemplary implementation modes, the display panel may also include at least one shielding electrode located in the second bezel region. In a direction perpendicular to the display panel, the shielding electrode may be located between at least a part of line segments of the at least one detection connection line and the at least one data leading-out line. An orthographic projection of the shielding electrode on the base substrate may cover an overlapping portion between an orthographic projection of the at least one detection connection line on the base substrate and an orthographic projection of the at least one data leading-out line on the base substrate. In this example, by providing the shielding electrode in the second bezel region, the shielding electrode may be used to separate the detection connection line and the data leading-out line, thereby reducing a coupling capacitance between the detection connection line and the data leading-out line, reducing interference of the coupling capacitance on the data signal, thus improving display quality of the display panel, and reducing a risk of poor display of the display panel.

In some exemplary implementation modes, the display panel may also include a plurality of first power lines located in the display region and a first electrical power supply line located in the second bezel region. The plurality of first power lines may be electrically connected with a plurality of sub-pixels, the plurality of first power lines may be connected with the first electrical power supply line, and at least one shielding electrode may be connected with the first electrical power supply line. In some examples, a first power line and the first electrical power supply line may be configured to provide high-level signals. In this example, a shielding effect of the shielding electrode may be achieved by disposing the shielding electrode to be connected with the first electrical power supply line.

In some exemplary implementation modes, the first electrical power supply line may include a first sub-electrical power supply line and a second sub-electrical power supply line connected with each other, and the first sub-electrical power supply line may be located on a side of the second sub-electrical power supply line close to the base substrate. At least one shielding electrode and the first sub-electrical power supply line may be of an interconnected integral structure. In some examples, at least a part of line segments of at least one detection connection line and the second sub-electrical power supply line may be of a same layer structure. In other examples, at least one shielding electrode and the second sub-electrical power supply line may be of an interconnected integral structure; and at least a part of line segments of at least one detection connection line may be located on a side of the second sub-electrical power supply line away from the base substrate. In this example, the first power line is disposed to have a double-layer trace structure, which is beneficial to reducing an impedance of the first electrical power supply line; and moreover, the shielding electrode and one layer of traces of the first electrical power supply line are of an interconnected integral structure, which is beneficial to an arrangement of shielding electrodes and reduces a quantity of openings required for a connection of a shielding electrode and the first electrical power supply line.

In some exemplary implementation modes, the display structure layer may at least include a first gate metal layer, a second gate metal layer, a first source-drain metal layer, and a second source-drain metal layer which are disposed on the base substrate. An interlayer dielectric layer is provided between the second gate metal layer and the first source-drain metal layer, and at least a first planarization layer is provided between the first source-drain metal layer and the second source-drain metal layer. At least a part of line segments of at least one detection connection line is located in the second source-drain metal layer, and a shielding electrode is located in the first source-drain metal layer. An insulation layer between at least a part of line segments of the at least one detection connection line and the at least one data leading-out line at least includes an interlayer dielectric layer and a first planarization layer. An inorganic insulation layer between at least a part of the line segments of the detection connection line and the data leading-out line may include an interlayer dielectric layer, and an organic insulation layer may include a first planarization layer. In this example, at least the interlayer dielectric layer and the first planarization layer are provided between at least a part of line segments of the detection connection line and the data leading-out line, which may increase a distance between the detection connection line and the data leading-out line of which an orthographic projection is overlapped with an orthographic projection of the detection connection line, thereby reducing a coupling capacitance between the detection connection line and the data leading-out line, and reducing interference of the coupling capacitance on a data signal. However, the present embodiment is not limited thereto. In other examples, an interlayer dielectric layer, a passivation layer, and a first planarization layer may be provided between the first source-drain metal layer and the second source-drain metal layer, wherein an inorganic insulation layer between at least a part of line segments of the detection connection line and the data leading-out line may include an interlayer dielectric layer and a passivation layer, and an organic insulation layer may include a first planarization layer.

In some exemplary implementation modes, the touch structure layer may include at least one touch conductive layer, and at least a part of the line segments of the at least one detection connection line may be located in the touch conductive layer of the touch structure layer. In this example, the detection connection line is disposed to be located in the touch conductive layer, a distance between the detection connection line and the data leading-out line of which the orthographic projection is overlapped with the orthographic projection of the detection connection line may be increased, thereby reducing a coupling capacitance between the detection connection line and the data leading-out line, and reducing interference of the coupling capacitance on a data signal.

In some exemplary implementation modes, the display structure layer may include a plurality of first crack detection lines, and the plurality of first crack detection lines may be symmetrically disposed with respect to a centerline of the display panel in a first direction. The touch structure layer may include a plurality of second crack detection lines, and the plurality of second crack detection lines may be disposed symmetrically with respect to the centerline of the display panel in the first direction. In some examples, plurality of detection connection lines of the second bezel region may be symmetrically disposed with respect to the centerline of the display panel in the first direction. In some examples, an orthographic projection of each data leading-out line on the base substrate may be overlapped with orthographic projections of a same quantity of detection connection lines on the base substrate. In this example, crack detection lines are disposed symmetrically and each data leading-out line is overlapped with the same quantity of detection connection lines, which may maintain consistency of coupling capacitances between a plurality of data leading-out lines and detection connection lines, thereby reducing a risk of poor display such as uneven brightness.

Solutions of this embodiment will be described below through a plurality of examples.

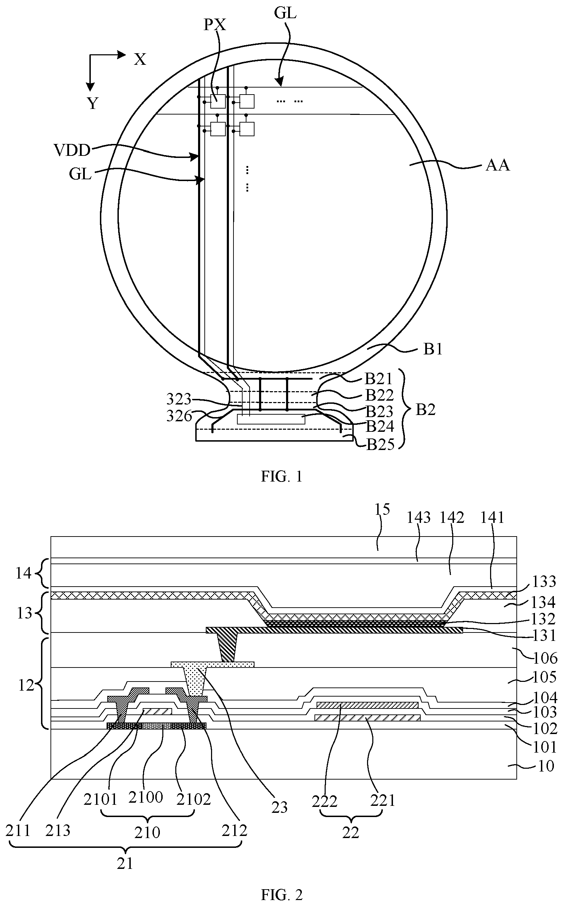

FIG. 1 is a schematic diagram of a display panel according to at least one embodiment of the present disclosure. In some examples, as shown in FIG. 1, the display panel may include a display region AA and a bezel region located at a periphery of the display region AA. The bezel region may include a second bezel region B2 located on a side of the display region AA and a first bezel region B1 located on remaining sides of the display region AA. The first bezel region B1 and the second bezel region B2 may be communicated. For example, the second bezel region B2 may be a lower bezel region of the display panel.

In some examples, as shown in FIG. 1, the display region AA may be a planar region including a plurality of sub-pixels PX forming a pixel array, the plurality of sub-pixels PX may be configured to display a dynamic picture or a static image. The display region AA may be referred to as an Active Area. In some examples, the display region AA may be in a shape of a circle or an oval. However, the present embodiment is not limited thereto. For example, the display region may be in another shape such as a shape of a rectangle. In some examples, the display panel may be a flexible panel, and accordingly the display region may be deformable, for example, may be crimped, bent, folded, or curled.

In some examples, as shown in FIG. 1, the display panel may include a display structure layer and a touch structure layer which are disposed sequentially on a base substrate. For example, in the display panel, a touch structure may be integrated to form a structure of Touch on Thin film Encapsulation (Touch on TFE for short). The structure of Touch on TFE mainly includes a Flexible Multi-Layer On Cell (FMLOC) structure and a Flexible Single-Layer On Cell (FSLOC) structure. The FMLOC structure is based on a working principle of mutual capacitance detection. Generally, a drive (Tx) electrode and a sensing (Rx) electrode are formed by using two layers of metal, and a drive chip (IC) achieves a touch action by detecting a mutual capacitance between the drive electrode and the sensing electrode. The FSLOC structure is based on a working principle of self-capacitance (or voltage) detection. Generally, a touch electrode is formed by using a single layer of metal, and an integrated circuit achieves a touch action by detecting a self-capacitance (or voltage) of the touch electrode.

In some examples, the display structure layer may include a plurality of sub-pixels PX, a plurality of gate lines GL, a plurality of data lines DL, and a plurality of first power lines VDD which are located in the display region AA. The plurality of gate lines GL may be arranged along a second direction Y, and each gate line GL may extend along a first direction X; the plurality of data lines DL may be arranged along the first direction X, and each data line DL may extend along the second direction Y; and the plurality of first power lines VDD may be arranged along the first direction X, and each first power line VDD may extend along the second direction Y. Orthographic projections of the plurality of gate lines GL on the base substrate may intersect with orthographic projections of the plurality of data lines DL on the base substrate, thereby forming a plurality of sub-pixel regions. One sub-pixel PX may be disposed within one sub-pixel region. The plurality of data lines DL may be electrically connected with the plurality of sub-pixels PX and the plurality of data lines DL may be configured to provide data signals to the plurality of sub-pixels PX. The plurality of gate lines GL may be electrically connected with the plurality of sub-pixels PX and the plurality of gate lines GL may be configured to provide gate drive signals to the plurality of sub-pixels PX. For example, the gate drive signals may include a scan signal, or may include a scan signal and a light emitting control signal, or may include a scan signal, a reset control signal, and a light emitting control signal. The plurality of first power lines VDD may be electrically connected with the plurality of sub-pixels PX, and the plurality of first power lines VDD may be configured to provide high-level signals to the plurality of sub-pixels PX.

In some examples, as shown in FIG. 1, the first direction X may be an extension direction (e.g., a row direction) of the gate lines GL in the display region AA, and the second direction Y may be an extension direction (e.g., a column direction) of the data lines DL in the display region AA. The first direction X and the second direction Y may intersect with each other, for example, they may be perpendicular to each other.

In some examples, one pixel unit of the display region AA may include three sub-pixels, which may be a first sub-pixel emitting a first color light (e.g., red light), a second sub-pixel emitting a second color light (e.g., green light), and a third sub-pixel emitting a third color light (e.g., blue light), respectively. However, the present embodiment is not limited thereto. In some examples, one pixel unit may include four sub-pixels, which may be a sub-pixel emitting red light, a sub-pixel emitting green light, a sub-pixel emitting blue light, and a sub-pixel emitting white light, respectively. For another example, one pixel unit may include four sub-pixels, which may include one sub-pixel emitting red light, one sub-pixel emitting blue light, and two sub-pixels emitting green light.

In some examples, one sub-pixel may include a pixel circuit and a light emitting element electrically connected with the pixel circuit. The pixel circuit may include a plurality of transistors and at least one capacitor. For example, the pixel circuit may have a 3T1C, 4T1C, 5T1C, 5T2C, 6T1C, 7T1C, or 8T1C structure. Herein, in the above circuit structure, T refers to a thin film transistor, C refers to a capacitor, a number before T represents a quantity of thin film transistors in the circuit, and a number before C represents a quantity of capacitors in the circuit.

In some examples, the plurality of transistors in the pixel circuit may be P-type transistors or may be N-type transistors. Using a same type of transistors in the pixel circuit may simplify a process flow, reduce process difficulties of the display panel, and improve a yield of products. In some other examples, the plurality of transistors in the pixel circuit may include a P-type transistor and an N-type transistor.

In some examples, low temperature poly silicon thin film transistors, or oxide thin film transistors, or both a low temperature poly silicon thin film transistor and an oxide thin film transistor may be used as the plurality of transistors in the pixel circuit. Low Temperature Poly Silicon (LTPS) is used for an active layer of a low temperature poly silicon thin film transistor and an oxide semiconductor (Oxide) is used for an active layer of an oxide thin film transistor. The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display panel, that is, an LTPS + Oxide (LTPO for short) display panel, so that advantages of both the low temperature poly silicon thin film transistor and the oxide thin film transistor may be utilized, low-frequency drive may be achieved, power consumption may be reduced, and display quality may be improved.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of a pixel circuit corresponding to the light emitting element. A color of light emitted by the light emitting element may be determined as required. In some examples, the light emitting element may include an anode, a cathode, and an organic emitting layer located between the anode and the cathode. The anode of the light emitting element may be electrically connected with a corresponding pixel circuit. However, the present embodiment is not limited thereto.

In some examples, a shape of the light emitting element of the sub-pixel may be a rectangle, a rhombus, a pentagon, or a hexagon. When one pixel unit includes three sub-pixels, light-emitting elements of the three sub-pixels may be arranged side by side horizontally, side by side vertically, or in a delta arrangement. When one pixel unit includes four sub-pixels, light-emitting elements of the four sub-pixels may be arranged side by side horizontally, side by side vertically, or in a manner to form a square. However, the present embodiment is not limited thereto.

FIG. 2 is a schematic partial cross-sectional view of a display region of a display panel according to at least one embodiment of the present disclosure. FIG. 2 is illustrated by taking a structure of one sub-pixel of the display region as an example. In the present example, description is given by taking a case that a plurality of transistors in a pixel circuit are of a same type as an example. For example, a plurality of transistors in a pixel circuit may all be low temperature poly silicon thin film transistors or may all be oxide thin film transistors.

In some examples, as shown in FIG. 2, in a direction perpendicular to the display panel, the display region of the display panel may include a base substrate 10, and a circuit structure layer 12, a light emitting structure layer 13, an encapsulation structure layer 14, and a touch structure layer 50 that are sequentially disposed on the base substrate 10. The display structure layer may include at least the circuit structure layer 12 and the light emitting structure layer 13. The circuit structure layer 12 may include at least pixel circuits of a plurality of sub-pixels, and a pixel circuit of each sub-pixel may include a plurality of transistors and at least one capacitor. The light emitting structure layer 13 may include at least light emitting elements of a plurality of sub-pixels.

In some examples, FIG. 2 is illustrated by taking one thin film transistor 21 and one capacitor 22 included in one sub-pixel as an example. In some examples, the circuit structure layer 12 of the display region may include: a semiconductor layer, a first gate metal layer, a second gate metal layer, a first source-drain metal layer, and a second source-drain metal layer, which are disposed on the base substrate 10. A first gate insulation layer 101 may be disposed between the semiconductor layer and the first gate metal layer, a second gate insulation layer 102 may be disposed between the first gate metal layer and the second gate metal layer, an interlayer dielectric layer 103 may be disposed between the second gate metal layer and the first source-drain metal layer, a passivation layer 104 and a first planarization layer 105 may be disposed between the first source-drain metal layer and the second source-drain metal layer, and a second planarization layer 106 may be disposed on a side of the second source-drain metal layer away from the base substrate 10. The first gate insulation layer 101, the second gate insulation layer 102, the interlayer dielectric layer 103, and the passivation layer 104 may be inorganic insulation layers, and the first planarization layer 105 and the second planarization layer 106 may be organic insulation layers. However, the present embodiment is not limited thereto. In other examples, a side of the semiconductor layer close to the base substrate may also be provided with a buffer layer, which may prevent harmful substances in the base substrate from intruding into interior of the display panel, and may also increase adhesion of a film layer in the display panel on the base substrate. In other examples, only the first planarization layer 105 may be provided between the first source-drain metal layer and the second source-drain metal layer.

In some examples, as shown in FIG. 2, the semiconductor layer of the display region may include at least an active layer 210 of the thin film transistor 21. The active layer 210 of the thin film transistor 21 may include a first region 2101, a second region 2102, and a channel region 2100 located between the first region 2101 and the second region 2102. The first gate metal layer may include at least a gate 213 of the thin film transistor 21 and a first electrode plate 221 of the capacitor 22. An orthographic projection of the gate 213 of the thin film transistor 21 on the base substrate 10 may cover an orthographic projection of the channel region 2100 of the active layer 210 on the base substrate 10. The second gate metal layer may include at least a second electrode plate 222 of the capacitor 22. Orthographic projections of the second electrode plate 222 and the first electrode plate 221 of the capacitor 22 on the base substrate 10 may be at least partially overlapped, for example, the two may coincide. The first source-drain metal layer may include at least a first electrode 211 and a second electrode 212 of the thin film transistor 21. The interlayer dielectric layer 103 may be provided with a plurality of vias (for example, including a first pixel via and a second pixel via) in the display region, and the interlayer dielectric layer 103, the second gate insulation layer 102, and the first gate insulation layer 101 within the first pixel via may be removed to expose at least a part of a surface of the first region 2101 of the active layer 210; the interlayer dielectric layer 103, the second gate insulation layer 102, and the first gate insulation layer 101 within the second pixel via may be removed to expose at least a part of a surface of the second region 2102 of the active layer 210. The first electrode 211 of the thin film transistor 21 may be electrically connected with the first region 2101 of the active layer 210 through the first pixel via, and the second electrode 212 may be electrically connected with the second region 2102 of the active layer 210 through the second pixel via. The second source-drain metal layer may at least include an anode connection electrode 23. The anode connection electrode 23 may be connected with the second electrode 212 of the thin film transistor 21 through a via opened in the passivation layer 104 and the first planarization layer 105. In some examples, a gate line of the display region, for example, may be located in the first gate metal layer, and a data line and a high-potential power line of the display region, for example, may be located in the second source-drain metal layer. However, the present embodiment is not limited thereto. In other examples, a third planarization layer and a third source-drain metal layer may be provided on a side of the second source-drain metal layer away from the base substrate, and a data line and a high-potential power line of the display region may be located in the third source-drain metal layer.

In some examples, as shown in FIG. 2, the light emitting structure layer 13 may include a pixel definition layer 134 and a plurality of light emitting elements. For example, each light emitting element may include a first electrode 131, an organic emitting layer 132, and a second electrode 133 which are stacked. The first electrode 131 of the light emitting element may be an anode, and the first electrode 131 may be provided on the second planarization layer 106 and electrically connected with the anode connection electrode 23 through a pixel via opened in the second planarization layer 106. The pixel definition layer 134 is provided on the first electrode 131 and the second planarization layer 106, and may be provided with a plurality of pixel openings, one pixel opening may expose at least portion of a surface of a corresponding first electrode 131. At least portion of the organic emitting layer 132 may be disposed within one pixel opening and connected with a corresponding first electrode 131. The second electrode 133 may be disposed on the organic emitting layer 132 and be connected with the organic emitting layer 132. The organic emitting layer 132 may emit light of a corresponding color under drive of the first electrode 131 and the second electrode 133.

In some examples, the organic emitting layer 132 of the light emitting element may include an Emitting Layer (EML), and include one or more film layers of following: a Hole Injection Layer (HIL), a Hole Transport Layer (HTL), a Hole Block Layer (HBL), an Electron Block Layer (EBL), an Electron Injection Layer (EIL), and an Electron Transport Layer (ETL). Under drive of voltages of the first electrode 131 and the second electrode 133, light may be emitted according to a required gray scale, in virtue of light emitting characteristics of an organic material.

In some examples, the emitting layers of light emitting elements emitting light of different colors may be different. For example, a red light emitting element may include a red emitting layer, a green light emitting element may include a green emitting layer, and a blue light emitting element may include a blue emitting layer. In order to reduce a process difficulty and improve a yield, a common layer may be adopted for a hole injection layer and a hole transport layer located on one side of an emitting layer, and a common layer may be adopted for an electron injection layer and an electron transport layer located on the other side of the emitting layer. In some examples, any one or more layers of the hole injection layer, the hole transport layer, the electron injection layer, and the electron transport layer may be made through one process (one evaporation process or one inkjet printing process), and isolation may be achieved by means of a formed film layer surface segment difference or by means of a surface treatment. For example, any one or more of hole injection layers, hole transport layers, electron injection layers, and electron transport layers corresponding to adjacent sub-pixels may be isolated. In some examples, the organic emitting layer may be prepared and formed through evaporation using a Fine Metal Mask (FMM for short) or an open mask, or prepared and formed using an inkjet process.

In some examples, as shown in FIG. 2, the encapsulation structure layer 14 may include a first encapsulation layer 141, a second encapsulation layer 142, and a third encapsulation layer 143 which are stacked. The first encapsulation layer 141 and the third encapsulation layer 143 may be made of an inorganic material, the second encapsulation layer 142 may be made of an organic material, and the second encapsulation layer 142 is disposed between the first encapsulation layer 141 and the third encapsulation layer 143 to ensure that external water vapor cannot enter the light emitting element. However, the present embodiment is not limited thereto. For example, an encapsulation structure layer may be of a five-layer stacked structure of inorganic/organic/inorganic/organic/inorganic.

In some examples, the touch structure layer 15 may include a plurality of touch units. At least one touch unit may include at least one touch electrode. An orthographic projection of the at least one touch electrode on the base substrate may include orthographic projections of a plurality of sub-pixels on the base substrate. When the touch unit includes a plurality of touch electrodes, the plurality of touch electrodes may be disposed at intervals, and adjacent touch electrodes may be connected with each other through a connection portion. A touch electrode and the connection portion may be of a same layer structure. In some examples, the touch electrode may be in a rhombus shape, such as a regular rhombus, a horizontally long rhombus, or a longitudinally long rhombus. However, the present embodiment is not limited thereto. In some examples, the touch electrode may be in any one or more shapes of a triangle, a square, a trapezoid, a parallelogram, a pentagon, a hexagon, and another polygon.

In some examples, taking a case that the display panel has an FSLOC structure as an example, the touch structure layer 15 may include a touch buffer layer, a first touch conductive layer, and a touch protection layer which are disposed sequentially on the encapsulation structure layer 14. The first touch conductive layer may include a plurality of touch electrodes and a plurality of connection portions. In other examples, taking a case that the display panel has an FMLOC structure as an example, the touch structure layer 15 may include a touch buffer layer, a first touch conductive layer, a touch insulation layer, a second touch conductive layer, and a touch protective layer which are disposed sequentially on the encapsulation structure layer 14. For example, the first touch conductive layer may include a plurality of connection portions, and the second touch conductive layer may include a plurality of touch electrodes. However, the present embodiment is not limited thereto.

In some examples, as shown in FIG. 1, the second bezel region B2 may include a first fanout region B21, a bending region B22, a second fanout region B23, a first signal access region B24, and a second signal access region B25 which are disposed sequentially along a direction away from the display region AA. The first fanout region B21 may communicate with the first bezel region B1 and be located on a side of the display region AA. The first fanout region B21 may be provided with a plurality of data fanout lines and a first power supply transmission line, wherein the plurality of data fanout lines may be connected with a plurality of data lines DL of the display region AA, and the first power supply transmission line may be connected with a plurality of first power lines VDD of the display region AA.

In some examples, as shown in FIG. 1, the bending region B22 may communicate with the first fanout region B21 and the second fanout region B23 and be located on a side of the first fanout region B21 away from the display region AA. The bending region B22 may enable the second fanout region B23, the first signal access region B24, and the second signal access region B25 to be bent to a back of the display region AA. The bending region B22 may include a plurality of bending connection lines to achieve a connection between traces for transmitting a same signal in the first fanout region B21 and the second fanout region B23.

In some examples, as shown in FIG. 1, the second fanout region B23 may be located on a side of the bending region B22 away from the display region AA. The second fanout region B23 may be provided with a plurality of data leading-out lines 323 and a first electrical power supply line 326. The plurality of data leading-out lines 323 may be connected with the plurality of data fanout lines in the first fanout region B21 through the plurality of data bending lines in the bending region B22 to achieve providing data signals to the plurality of data lines DL in the display region AA. The first electrical power supply line 326 may be connected with the first power supply transmission line in the first fanout region B21 through a first voltage bending line in the bending region B22 to achieve being connected with a plurality of first power lines VDD in the display region AA.

In some examples, as shown in FIG. 1, the first signal access region B24 may be located on a side of the second fanout region B23 away from the display region AA. The first signal access region B24 may be configured to provide a drive chip (Integrated Circuit (IC)), for example, the drive chip provided in the first signal access region B24 may be a Touch and Display Driver Integration (TDDI). The first signal access region B24 may also be referred to as a drive chip disposing region. The drive chip may be configured to generate a data signal required for driving a sub-pixel, provide a touch drive signal to the touch unit and receive a touch signal generated by the touch unit, and generate a crack detection drive signal and receive a crack detection signal.

In some examples, as shown in FIG. 1, the second signal access region B25 may be located on a side of the first signal access region B24 away from the display region AA. The second signal access region B25 may be provided with a plurality of contact pads, which may be configured to bond a Flexible Printed Circuit (FPC), such that a plurality of signal lines (e.g., power lines, control signal lines, etc.) are connected with an external control apparatus through the plurality of contact pads. The second signal access region B25 may also be referred to as a circuit bonding region.

In some examples, the display panel may include a Panel Crack Detection (PCD) circuit, which may be configured to detect whether there is a crack in the display panel. For example, the Panel Crack Detection circuit may include at least one first crack detection line and at least one second crack detection line. The first crack detection line may be configured to detect whether there is a crack in the display structure layer, and the second crack detection line may be configured to detect whether there is a crack in the touch structure layer. The first crack detection line and the second crack detection line may perform crack detection in a resistance detection manner. The resistance detection manner refers to: detecting a resistance of a crack detection line from two ends of the crack detection line, so as to determine whether the crack detection line is broken, and then infer whether the display panel is broken. In some examples, the first crack detection line and the second crack detection line may be connected with a drive IC, which may control a crack detection process of the display panel.

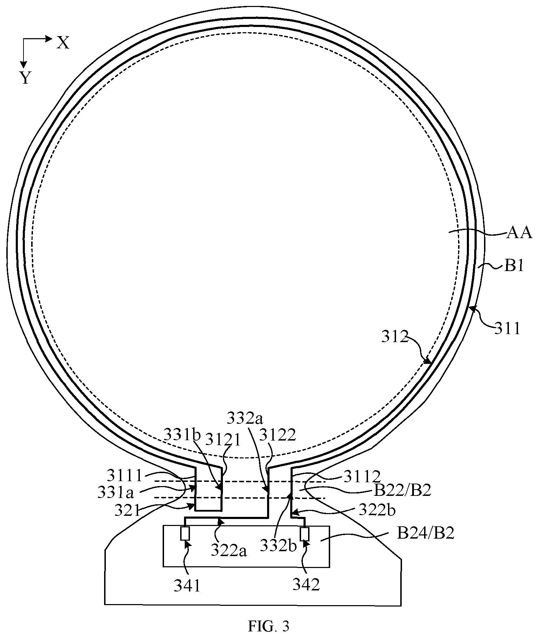

FIG. 3 is a schematic diagram of crack detection of a display panel according to at least one embodiment of the present disclosure. In some examples, as shown in FIG. 3, the display structure layer may include at least a first crack detection line 311 located in the first bezel region B1; and the touch structure layer may include at least a second crack detection line 312 located in the first bezel region B1. The present example is illustrated by taking the first crack detection line 311 and the second crack detection line 312 as examples. Within the first bezel region B1, the first crack detection line 311 and the second crack detection line 312 may surround a periphery of the display region AA, and the first crack detection line 311 may be located on a side of the second crack detection line 312 away from the display region AA. In other words, within the first bezel region B1, the first crack detection line 311 may surround a periphery of the second crack detection line 312. However, the present embodiment is not limited thereto. In other examples, an orthographic projection of the first crack detection line on the base substrate may be overlapped with an orthographic projection of the second crack detection line on the base substrate.

In some examples, the first crack detection line 311 may include a first end 3111 and a second end 3112. The first end 3111 and the second end 3112 may extend from the first bezel region B1 to a first fanout region of the second bezel region B2. The second crack detection line 312 may include a first end 3121 and a second end 3122. The first end 3121 and the second end 3122 of the second crack detection line 312 may extend from the first bezel region B1 to a first fanout region of the second bezel region B2. In the first direction X, the first end 3111 of the first crack detection line 311, the first end 3121 of the second crack detection line 312, the second end 3122 of the second crack detection line 312, and the second end 3112 of the first crack detection line 311 may be arranged sequentially.

In some examples, the bending region B22 of the second bezel region B2 may at least include: a plurality of detection bending lines (including, for example, first detection bending lines 331a and 331b, second detection bending lines 332a and 332b). The first detection bending lines 331a and 331b and the second detection bending lines 332a and 332b may be arranged sequentially along the first direction X. The first detection bending line 331a may be connected with the first end 3111 of the first crack detection line 311, and the first detection bending line 331b may be connected with the first end 3121 of the second crack detection line 312. The second detection bending line 332a may be connected with the second end 3122 of the second crack detection line 312, and the second detection bending line 332b may be connected with the second end 3112 of the first crack detection line 311.

In some examples, the second fanout region B23 of the second bezel region B2 may at least include: a plurality of detection connection lines (including, for example, a first detection connection line 321, second detection connection lines 322a and 322b). One end of the first detection connection line 321 may be connected with the first end 3111 of the first crack detection line 311 through the first detection bending line 331a, and the other end may be connected with the first end 3121 of the second crack detection line 312 through the first detection bending line 331b. The first detection connection line 321 may connect the first end 3111 of the first crack detection line 311 and the first end 3121 of the second crack detection line 312 in series. The second detection connection line 322a may be connected with the second end 3122 of the second crack detection line 312 through the second detection bending line 332a, and the second detection connection line 322b may be connected with the second end 3112 of the first crack detection line 311 through the second detection bending line 332b.

In some examples, the first signal access region B24 may include at least two detection contact pads (including, for example, at least one first detection contact pad 341 and at least one second detection contact pad 342). The first detection contact pad 341 and the second detection contact pad 342 may be arranged along a side of the first signal access region B24 close to the display region AA. The second detection connection line 322a may be connected with the first detection contact pad 341, and the second detection connection line 322b may be connected with the second detection contact pad 342. The second detection connection lines 322a and 322b may achieve a connection between the first crack detection line 311 and the second crack detection line 312 connected in series and detection contact pads.

In this example, the first end 3111 of the first crack detection line 311 may be connected with the first end 3121 of the second crack detection line 312 through the first detection bending line 331a, the first detection connection line 321, and the first detection bending line 331b sequentially, the second end 3122 of the second crack detection line 312 may be connected with the first detection contact pad 341 through the second detection bending line 332a and the second detection connection line 322a sequentially, and the second end 3112 of the first crack detection line 311 may be connected with the second detection contact pad 342 through the second detection bending line 332b and the second detection connection line 322b sequentially. In this way, the first crack detection line 311 and the second crack detection line 312 may be connected in series between the first detection contact pad 341 and the second detection contact pad 342. For example, the second detection contact pad 342 may transmit a crack detection drive signal generated by the drive IC, and the drive IC determines whether the display panel has a crack by detecting the crack detection signal received by the first detection contact pad 341.

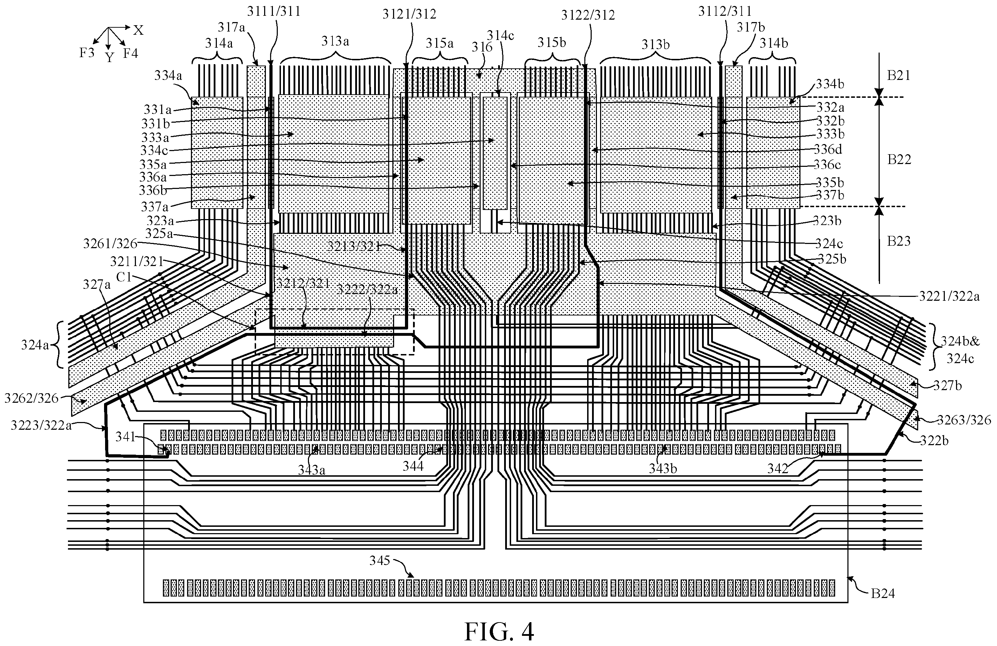

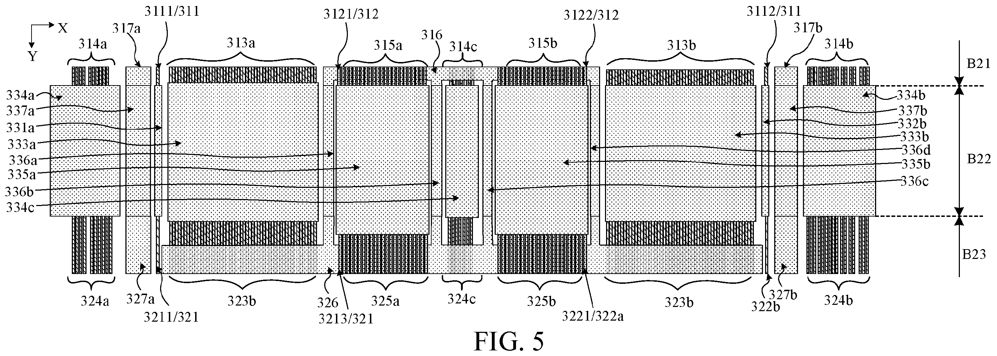

FIG. 4 is a partial schematic diagram of a second bezel region of a display panel according to at least one embodiment of the present disclosure. FIG. 5 is a schematic diagram of an arrangement of traces of a bending region of a second bezel region according to at least one embodiment of the present disclosure.

In some examples, as shown in FIGs. 4 and 5, the first end 3111 and the second end 3112 of the first crack detection line 311, and the first end 3121 and the second end 3122 of the second crack detection line 312 which are located in the first bezel region may extend to the first fanout region B21 of the second bezel region B2. The first fanout region B21 of the second bezel region B2 may further include a plurality of data fanout lines, a plurality of drive fanout lines, a plurality of touch fanout lines, a first power supply transmission line 316, and second power supply transmission lines 317a and 317b.

In some examples, a plurality of data fanout lines may be connected with a plurality of data lines of the display region AA. For example, the first bezel region B1 may be provided with a plurality of multiplexing circuits (MUX), and a plurality of data fanout lines and a plurality of data lines may be connected with the plurality of multiplexing circuits to transmit a path of data signal provided by each data fanout line to a plurality of data lines (e.g., three, six, or nine data lines). The plurality of data fanout lines may include a first set of data fanout lines 313a and a second set of data fanout lines 313b. For example, the first set of data fanout lines 313a may be connected with a plurality of data lines within a left half region of the display region AA, and the second set of data fanout lines 313b may be connected with a plurality of data lines within a right half region of the display region AA.

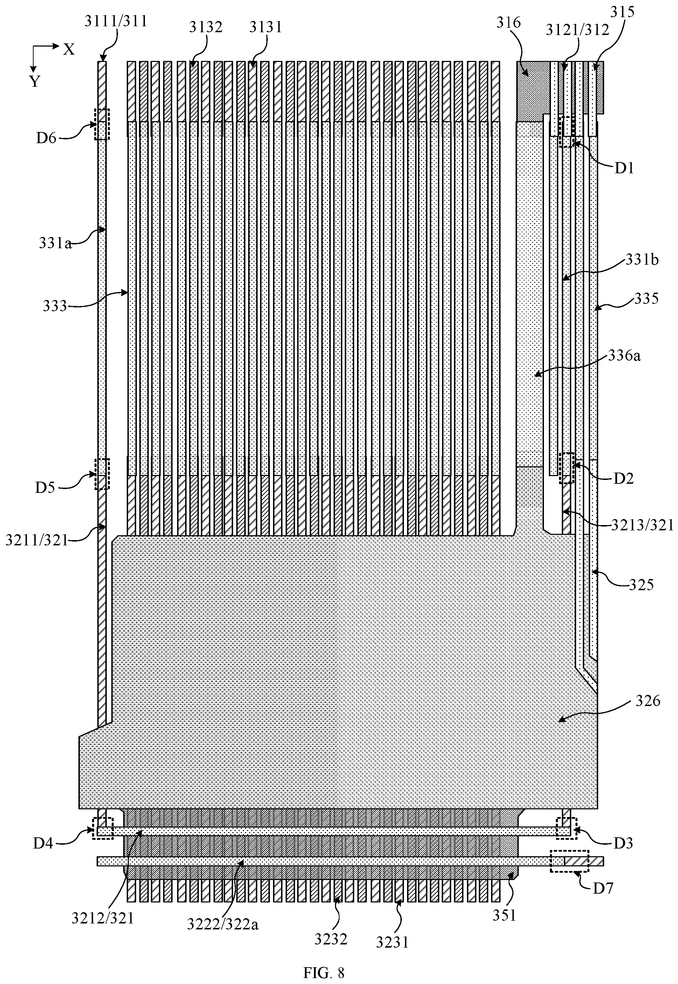

In some examples, the plurality of data fanout lines may include: a plurality of first data fanout lines located in the first gate metal layer (e.g., the first data fanout lines 3131 shown in FIG. 8) and a plurality of second data fanout lines located in the second gate metal layer (e.g.,the second data fanout lines 3132 shown in FIG. 8). The plurality of first data fanout lines and the plurality of second data fanout lines may be disposed at intervals along the first direction X, and orthographic projections of the first data fanout lines on the base substrate may not be overlapped with orthographic projections of the second data fanout lines on the base substrate. In this example, a plurality of data fanout lines are alternately arranged in two conductive layers, which may help save a gap between adjacent traces, thereby saving arrangement space of data fanout lines.

In some examples, the plurality of drive fanout lines may be configured to provide drive signals (including, for example, a clock signal, a drive control signal, a start signal, and the like) to at least one gate drive circuit provided within the first bezel region B1. The plurality of drive fanout lines may include a first set of drive fanout lines 314a, a second set of drive fanout lines 314b, and a third set of drive fanout lines 314c. The third set of drive fanout lines 314c may be located between the first set of drive fanout lines 314a and the second set of drive fanout lines 314b, the first set of drive fanout lines 314a may be located on a side of the first set of data fanout lines 313a in an opposite direction of the first direction X, the second set of drive fanout lines 314b may be located on a side of the second set of data fanout lines 313b in the first direction X, and the third set of drive fanout lines 314c may be located between the first set of data fanout lines 313a and the second set of data fanout lines 313b. In some examples, a plurality of drive fanout lines of the first set of drive fanout lines 314a and the second set of drive fanout lines 314b may be located in the second gate metal layer, and a plurality of drive fanout lines of the third set of drive fanout lines 314c may be located in the first gate metal layer. However, the present embodiment is not limited thereto.

In some examples, a plurality of touch fanout lines may be configured to be connected with a plurality of touch connection lines provided within the first bezel region B1, and a plurality of touch connection lines may be connected with a plurality of touch units of the display region AA so as to transmit touch signals. The plurality of touch fanout lines may include a first set of touch fanout lines 315a and a second set of touch fanout lines 315b. The first set of touch fanout lines 315a may be located between the first set of data fanout lines 313a and the third set of drive fanout lines 314c, and the second set of touch fanout lines 315b may be located between the second set of data fanout lines 313b and the third set of drive fanout lines 314c. In some examples, a plurality of touch fanout lines of the first set of touch fanout lines 315a and the second set of touch fanout lines 315b may be located in the first touch conductive layer. However, the present embodiment is not limited thereto. In other examples, a plurality of touch fanout lines may be located in the second touch conductive layer.

In some examples, the first power supply transmission line 316 may be located in the second source-drain metal layer or may be a double-layer trace located in the first source-drain metal layer and the second source-drain metal layer. An orthographic projection of the first power supply transmission line 316 on the base substrate may be partially overlapped with orthographic projections of the first set of touch fanout lines 315a, the second set of touch fanout lines 315b, and the third set of drive fanout lines 314c on the base substrate.

In some examples, the second power supply transmission line 317a may be located on a side of the first set of data fanout lines 313a away from the first power supply transmission line 316, and the second power supply transmission line 317b may be located on a side of the second set of data fanout lines 313b away from the first power line 316. The second power supply transmission line 317a and the second power supply transmission line 317b may be located in the second source-drain metal layer, or may be a double-layer trace located in the first source-drain metal layer and the second source-drain metal layer.

In some examples, the first end 3111 of the first crack detection line 311 may be located between the second power supply transmission line 317a and the first set of data fanout lines 313a. The first end 3111 of the first crack detection line 311 may be located in the first gate metal layer. The second end 3112 of the first crack detection line 311 may be located between the second power supply transmission line 317b and the second set of data fanout lines 313b. The second end 3112 of the first crack detection line 311 may be located in the first gate metal layer. The first crack detection line 311 may be located in the second gate metal layer in the first bezel region, or may be located in the first source-drain metal layer, or may be wound and arranged in the second gate metal layer and the first source-drain metal layer.

In some examples, the first end 3121 of the second crack detection line 312 may be located between the first set of data fanout lines 313a and the first set of drive fanout lines 315a. The second end 3122 of the second crack detection line 312 may be located between the second set of data fanout lines 313b and the second set of drive fanout lines 315b. Orthographic projections of the first end 3121 and the second end 3122 of the second crack detection line 312 on the base substrate may be partially overlapped with an orthographic projection of the first power supply transmission line 316 on the base substrate. The first end 3121 and the second end 3122 of the second crack detection line 312 may be located in the first touch conductive layer. The second crack detection line 312 may be located in the first touch conductive layer in the first bezel region B1. However, the present embodiment is not limited thereto. In other examples, the second crack detection line may be located in the second touch conductive layer.

In some examples, as shown in FIGs. 4 and 5, the bending region B22 may include a plurality of bending connection lines, for example, may include first detection bending lines 331a and 331b, second detection bending lines 332a and 332b, a plurality of data bending lines (including a first set of data bending lines 333a and a second set of data bending lines 333b), a plurality of drive bending lines (including a first set of drive bending lines 334a, a second set of drive bending lines 334b, and a third set of drive bending lines 334c), a plurality of touch bending lines (including a first set of touch bending lines 335a and a second set of touch bending lines 335b), a plurality of first power supply bending lines (including first power supply bending lines 336a, 336b, 336c, and 336d), and a plurality of second power supply bending lines (e.g., including second power supply bending lines 337a and 337b). A same type of adjacent bending connection lines are illustrated as a whole in FIG. 4 and FIG. 5.

In some examples, in the bending region B22, the first set of drive bending lines 334a, the second power supply bending line 337a, the first detection bending line 331a, the first set of data bending lines 333a, the first power supply bending line 336a, the first detection bending line 331b, the first set of touch bending lines 335a, the first power supply bending line 336b, the third set of drive bending lines 334c, the first power supply bending line 336c, the second set of touch bending lines 335b, the second detection bending line 332a, the first power supply bending line 336d, the second set of data bending lines 333b, the second detection bending line 332b, the second power supply bending line 337b, and the second set of drive bending lines 334b may be disposed sequentially in the first direction X.

In some examples, the first set of drive bending lines 334a may be connected with the first set of drive fanout lines 314a; the second set of drive bending lines 334b may be connected with the second set of drive fanout lines 314b; and the third set of drive bending lines 334c may be connected with the third set of drive fanout lines 314c. The first set of data bending lines 333a may be connected with the first set of data fanout lines 313a, and the second set of data bending lines 333b may be connected with the second set of data fanout lines 313b. The first set of touch bending lines 335a may be connected with the first set of touch fanout lines 315a, and the second set of touch bending lines 335b may be connected with the second set of touch fanout lines 315b. The first power supply bending lines 336a, 336b, 336c, and 336d may be connected with the first power supply transmission line 316. The second power supply bending line 337a may be connected with the second power supply transmission line 317a, and the second power supply bending line 337b may be connected with the second power supply transmission line 317b.

In some examples, the first detection bending line 331a may be connected with the first end 3111 of the first crack detection line 311, and the first detection bending line 331b may be connected with the first end 3121 of the second crack detection line 312. The second detection bending line 332a may be connected with the second end 3122 of the second crack detection line 312, and the second detection bending line 332b may be connected with the second end 3112 of the first crack detection line 311.

In some examples, a plurality of bending connection lines within the bending region B22 may be disposed in a same layer, all of which may be located, for example, in the second source-drain metal layer. However, the present embodiment is not limited thereto. In other examples, the plurality of bending connection lines of the bending region may be located in the first source-drain metal layer or the third source-drain metal layer.

In some examples, the second fanout region B23 may include a first detection connection line 321, second detection connection lines 322a and 322b, a plurality of data leading-out lines (including, for example, a first set of data leading-out lines 323a and a second set of data leading-out lines 323b), a plurality of drive leading-out lines (including, for example, a first set of drive leading-out lines 324a, a second set of drive leading-out lines 324b and a third set of drive leading-out lines 324c), a plurality of touch leading-out lines (including, for example, a first set of touch leading-out lines 325a and a second set of touch leading-out lines 325b), a first electrical power supply line 326, and second electrical power supply lines 327a and 327b.

In some examples, the first signal access region B24 may include a plurality of detection contact pads (e.g., including at least one first detection contact pad 341 and at least one second detection contact pad 342), a plurality of data contact pads (e.g., including a first set of data contact pads 343a and a second set of data contact pads 343b), a plurality of touch contact pads 344, and a plurality of transmission contact pads 345.

In some examples, the plurality of transmission contact pads 345 may be arranged along the first direction X and arranged along a side of the first signal access region B24 away from the display region AA. The plurality of transmission contact pads 345 may be connected with a plurality of contact pads within the second signal access region B25 through a plurality of pin connection lines.

In some examples, a plurality of detection contact pads, a plurality of data contact pads, and a plurality of touch contact pads may be arranged along a side of the first signal access region B24 close to the display region AA. The plurality of data contact pads and the plurality of touch contact pads 344 may be located between the first detection contact pad 341 and the second detection contact pad 342. The plurality of touch contact pads 344 may be located between the first set of data contact pads 343a and the second set of data contact pads 343b. The first detection contact pad 341 may be located on a side of the first set of data contact pads 343a away from a touch contact pad 344, and the second detection contact pad 342 may be located on a side of the second set of data contact pads 343b away from a touch contact pad 344.

In some examples, the first set of drive leading-out lines 324a may be connected with the first set of drive bending lines 334a, the second set of drive leading-out lines 324b may be connected with the second set of drive bending lines 334b, and the third set of drive leading-out lines 324c may be connected with the third set of drive bending lines 334c. The first set of drive leading-out lines 324a may extend substantially along a third direction F3, which intersects with both a first direction X and a second direction Y. The second set of drive leading-out lines 324b may extend substantially along a fourth direction F4, which intersects with both the first direction X and the second direction Y, and intersects with the third direction F3. For example, the third direction F3 and the fourth direction F4 may be substantially symmetrical with respect to the second direction Y. The third set of drive leading-out lines 324c may extend along the second direction Y, the first direction X, and the fourth direction F4 sequentially. The third set of drive leading-out lines 324c may be located in the middle of a plurality of drive leading-out lines of the second set of drive leading-out lines 324b.

In some examples, the first set of drive leading-out lines 324a, the second set of drive leading-out lines 324b, and the third set of drive leading-out lines 324c may be located in the second gate metal layer. However, the present embodiment is not limited thereto.

In some examples, the first set of data leading-out lines 323a may be connected with the first set of data bending lines 333a; and the second set of data leading-out lines 323b may be connected with the second set of data bending lines 333b. The first set of data leading-out lines 323a and the second set of data leading-out lines 323b may extend substantially along the second direction Y. The first set of data leading-out lines 323a may be connected with the first set of data contact pads 343a within the first signal access region B24, and the second set of data leading-out lines 323b may be connected with the second set of data contact pads 343b within the first signal access region B24.

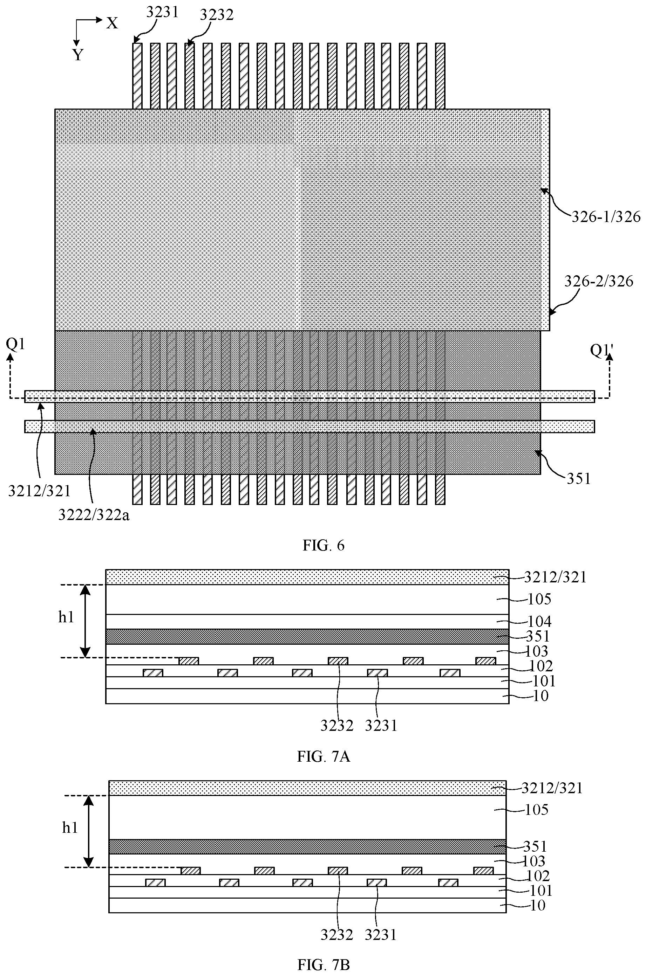

In some examples, the plurality of data leading-out lines may include a plurality of first data leading-out lines (e.g., the first data leading-out lines 3231 shown in FIG. 6) located in the first gate metal layer and a plurality of second data leading-out lines (e.g., the second data leading-out lines 3232 shown in FIG. 6) located in the second gate metal layer. The plurality of first data leading-out lines and the plurality of second data leading-out lines may be disposed at intervals along the first direction X, and an orthographic projection of a first data leading-out line on the base substrate may not be overlapped with an orthographic projection of a second data leading-out line on the base substrate. In this example, the plurality of data leading-out lines are alternately disposed in two conductive layers, which may help save a gap between adjacent traces, thereby saving arrangement space of data leading-out lines.

In some examples, the first set of touch leading-out lines 325a may be connected with the first set of touch bending lines 335a, and the second set of touch leading-out lines 325b may be connected with the second set of touch bending lines 335b. The first set of touch leading-out lines 325a and the second set of touch leading-out lines 325b may extend substantially along the second direction Y and are connected with a plurality of touch contact pads 344 within the first signal access region B24. The first set of touch leading-out lines 325a and the second set of touch leading-out lines 325b may be located between the first set of data leading-out lines 323a and the second set of data leading-out lines 323b.

In some examples, a plurality of touch leading-out lines of the first set of touch leading-out lines 325a and the second set of touch leading-out lines 325b may be located in the first touch conductive layer. However, the present embodiment is not limited thereto. In other examples, a plurality of touch leading-out lines may be located in the second touch conductive layer.

In some examples, the second electrical power supply line 327a may be connected with the second power supply bending line 337a, and the second electrical power supply line 327b may be connected with the second power supply bending line 337b. The second electrical power supply line 327a may extend substantially along the third direction F3 and be located between the first set of drive leading-out lines 324a and the first electrical power supply line 326. The second electrical power supply line 327b may extend substantially along the fourth direction F4 and be located between the second set of drive leading-out lines 324b and the first electrical power supply line 326.

In some examples, the second electrical power supply lines 327a and 327b may be located in the second source-drain metal layer, or may be a double-layer trace located in the first source-drain metal layer and the second source-drain metal layer. The present embodiment is not limited thereto.

In some examples, the first electrical power supply line 326 may be connected with the first power supply bending lines 336a, 336b, 336c, and 336d. The first electrical power supply line 326 may include: a first power supply extension segment 3261, a second power supply extension segment 3262, and a third power supply extension segment 3263. The first power supply extension segment 3261 may be connected between the second power supply extension segment 3262 and the third power supply extension segment 3263. The first power supply extension segment 3261 may be substantially in a shape of a strip extending along the first direction X, the second power supply extension segment 3262 may be substantially in a shape of a strip extending along the third direction F3, and the third power supply extension segment 3263 may be substantially in a shape of a strip extending along the fourth direction F4. The first power supply extension segment 3261 may be connected with the first power supply bending lines 336a, 336b, 336c, and 336d in one-to-one correspondence through four protrusions.

In some examples, the first electrical power supply line 326 may be a double-layer trace located in the first source-drain metal layer and the second source-drain metal layer. However, the present embodiment is not limited thereto. In other examples, the first electrical power supply line may be located in the second source-drain metal layer or the first source-drain metal layer.

In some examples, the first detection connection line 321 may include a first extension segment 3211, a second extension segment 3212, and a third extension segment 3213 connected sequentially. The first extension segment 3211 and the third extension segment 3213 may be substantially in a shape of a straight line extending along the second direction Y, and the second extension segment 3212 may be substantially in a shape of a straight line extending along the first direction X. The second extension segment 3212 is connected between the first extension segment 3211 and the third extension segment 3213. The first extension segment 3211 may be connected with the first detection bending line 331a, and the third extension segment 3213 may be connected with the first detection bending line 331b. In this example, the first end 3111 of the first crack detection line 311 and the first end 3121 of the second crack detection line 312 may be connected in series through the first detection connection line 321 and the first detection bending lines 331a and 331b.

In some examples, the first extension segment 3211 of the first detection connection line 321 may be located between the second electrical power supply line 327a and the first set of data leading-out lines 323a, and the third extension segment 3213 may be located between the first set of data leading-out lines 323a and the first set of touch leading-out lines 325a. The second extension segment 3212 crosses the first set of data leading-out lines 323a to connect the first extension segment 3211 and the third extension segment 3213. An orthographic projection of the second extension segment 3212 on the base substrate is overlapped with orthographic projections of the first set of data leading-out lines 323a on the base substrate.

In some examples, the second detection connection line 322a may include a fourth extension segment 3221, a fifth extension segment 3222, and a sixth extension segment 3223 connected sequentially. The fourth extension segment 3221 may be in a shape of a polyline extending substantially along the second direction Y. The fifth extension segment 3222 may be in a shape of a polyline extending substantially along the first direction X. The sixth extension segment 3223 may be in a shape of a polyline extending substantially along the second direction Y. The fifth extension segment 3222 may be connected between the fourth extension segment 3221 and the sixth extension segment 3223. The fourth extension segment 3221 may be connected with the second detection bending line 332a, and the sixth extension segment 3223 may be connected with the first detection contact pad 341 within the first signal access region B24. The fifth extension segment 3222 may be located on a side of the first detection connection line 321 away from the bending region B22. For example, at least a part of the fifth extension segment 3222 and the second extension segment 3212 of the first detection connection line 321 may both be parallel to the first direction X and disposed sequentially in the second direction Y.

In some examples, the fourth extension segment 3221 of the second detection connection line 322a may be located between the second set of touch leading-out lines 325b and the second set of data leading-out lines 323b, and the sixth extension segment 3223 may be located between the first set of data leading-out lines 323a and the second power supply extension segment 3262 of the first electrical power supply line 326. The fifth extension segment 3222 crosses the first set of data leading-out lines 323a, the first set of touch leading-out lines 325a, and the second set of touch leading-out lines 325b to connect the fourth extension segment 3221 and the sixth extension segment 3223. An orthographic projection of the fifth extension segment 3222 on the base substrate is overlapped with orthographic projections of the first set of data leading-out lines 323a on the base substrate.

In some examples, the second detection connection line 322b may be substantially in a shape of a polyline extending along the second direction Y. One end of the second detection connection line 322b may be connected with the second bending detection line 332b, and the other end may be connected with the second detection contact pad 342 within the first signal access region B24. The second detection connection line 322b may be located between the second set of data leading-out lines 323b and the second electrical power supply line 327b. A part of the second detection connection line 322b may be located between the second electrical power supply line 327b and the third power supply extension segment 3263 of the first electrical power supply line 326. An orthographic projection of the second detection connection line 322b on the base substrate may not be overlapped with an orthographic projection of a data leading-out line on the base substrate.

In some examples, the first crack detection line 311 and the second crack detection line 312 are connected in series, so that orthographic projections of a plurality of data leading-out lines (e.g., including the first set of data leading-out lines 323a) of the second bezel region B2 on the base substrate are overlapped with orthographic projections of detection connection lines (e.g., including the second extension segment 3212 of the first detection connection line 321 and the fifth extension segment 3222 of the second detection connection line 322a) on the base substrate, thereby forming an overlapping capacitance. Variation of a crack detection signal transmitted by a detection connection line is very easy to cause jump of a data signal, which will cause the data signal transmitted by a data leading-out line to be disturbed by a parasitic capacitance, thus resulting in poor display like Mura such as uneven brightness. In the present example, the overlapping capacitance between the detection signal and the data signal may be reduced by providing a shielding electrode to shield a parasitic capacitance between a detection connection line and a data leading-out line, or by increasing a minimum thickness between the detection connection line and the data leading-out line, thereby reducing poor display like Mura such as uneven brightness.

FIG. 6 is a partially enlarged view of a region C1 in FIG. 4. FIG. 7A is a schematic partial cross-sectional view along a direction Q1-Q1' in FIG. 6. FIG. 7B is another schematic partial cross-sectional view along a Q1-Q1' direction in FIG. 6. In some examples, as shown in FIGs. 4 and 6, the first set of data leading-out lines 323a may include a plurality of first data leading-out lines 3231 located in the first gate metal layer and a plurality of second data leading-out lines 3232 located in the second gate metal layer. The plurality of first data leading-out lines 3231 and the plurality of second data leading-out lines 3232 may be disposed at intervals along the first direction X, and an orthographic projection of a first data leading-out line 3231 on the base substrate may not be overlapped with an orthographic projection of a second data leading-out line 3232 on the base substrate.

In some examples, the first electrical power supply line 326 may include a first sub-electrical power supply line 326-1 located in the first source-drain metal layer and a second sub-electrical power supply line 326-2 located in the second source-drain metal layer. The second sub-electrical power supply line 326-2 is connected with the first sub-electrical power supply line 326-1. For example, an orthographic projection of the second sub-electrical power supply line 326-2 on the base substrate may cover an orthographic projection of the first sub-electrical power supply line 326-1 on the base substrate. The present embodiment is not limited thereto.

In some examples, the second bezel region B2 may include a shielding electrode 351. The shielding electrode 351 may be located in the first source-drain metal layer. An orthographic projection of the shielding electrode 351 on the base substrate may be approximately in a shape of a rectangle. The shielding electrode 351 may be located on a side of the first power supply extension segment 3261 of the first electrical power supply line 326 away from the bending region B22. The shielding electrode 351 and the first sub-electrical power supply line 326-1 of the first electrical power supply line 326 may be of an interconnected integral structure.

In some examples, the second extension segment 3212 of the first detection connection line 321 and the fifth extension segment 3222 of the second detection connection line 322a may both be located in the second source-drain metal layer. An orthographic projection of the shielding electrode 351 on the base substrate may be partially overlapped with orthographic projections of the second extension segment 3212 of the first detection connection line 321 and the fifth extension segment 3222 of the second detection connection line 322a on the base substrate. An overlapping portion of an orthographic projection of the second extension segment 3212 of the first detection connection line 321 on the base substrate and orthographic projections of a plurality of data leading-out lines (including a plurality of first data leading-out lines 3231 and second data leading-out lines 3232) on the base substrate may be located within a range of the orthographic projection of the shield electrode 351 on the base substrate. An overlapping portion of an orthographic projection of the fifth extension segment 3222 of the second detection connection line 322a on the base substrate and orthographic projections of a plurality of data leading-out lines (including a plurality of first data leading-out lines 3231 and second data leading-out lines 3232) on the base substrate may be located within a range of the orthographic projection of the shield electrode 351 on the base substrate. In other words, the shielding electrode 351 may cover overlapping portions of orthographic projections of the first detection line 321 and the second detection line 322a on the base substrate and orthographic projections of the first set of data leading-out lines on the base substrate. In this example, the shielding electrode connected with the first electrical power supply line is disposed to cover a data leading-out line of which an orthographic projection is overlapped with an orthographic projection of a detection connection line, it may be beneficial to reduce a coupling capacitance between the data leading-out line and the detection connection line.

In some examples, as shown in FIG. 7A, a second gate insulation layer 102, an interlayer dielectric layer 103, a shielding electrode 351, a passivation layer 104, and a first planarization layer 105 may be provided between the second extension segment 3212 of the first detection connection line 321 located in the second source-drain metal layer and the first data leading-out line 3231 located in the first gate metal layer; and an interlayer dielectric layer 103, a shielding electrode 351, a passivation layer 104, and a first planarization layer 105 may be provided between the second extension segment 3212 of the first detection connection line 321 located in the second source-drain metal layer and the second data leading-out line 3232 located in the second gate metal layer. At least a shielding electrode 351 and three insulation layers (including an interlayer dielectric layer 103, a passivation layer 104, and a first planarization layer 105) are provided between a data leading-out line and the second extension segment 3212 of the first detection connection line 321.

In some examples, a minimum thickness between the second extension segment 3212 of the first detection connection line 321 and the data leading-out line may be a minimum distance between a surface of the second extension segment 3212 close to the base substrate 10 and a surface of the data leading-out line away from the base substrate 10, which may be, for example, a minimum distance between a surface of the second data leading-out line 3232 away from the base substrate 10 and a surface of the second extension segment 3212 close to the base substrate 10. For example, a minimum thickness h1 may be greater than 2.1 microns. In this example, the coupling capacitance between the first detection connection line and the data leading-out line may be reduced by increasing the minimum thickness between the second extension segment 3212 of the first detection connection line 321 and the data leading-out line. Similarly, a minimum thickness between the fifth extension segment 3222 of the second detection connection line 322a and the data leading-out line may be greater than 2.1 microns.

In some examples, a thickness of the passivation layer 104 may be 0.025 micron to 0.033 micron, for example, may be about 0.03 micron; and a thickness of the first planarization layer 105 may be 1.35 microns to 1.65 microns, for example, may be about 1.5 microns. In this example, a thickness of a film layer may refer to a vertical distance between a surface of the film layer away from the base substrate and a surface of the film layer close to the base substrate.

In some examples, as shown in FIG. 7B, a second gate insulation layer 102, an interlayer dielectric layer 103, a shielding electrode 351, and a first planarization layer 105 may be provided between the second extension segment 3212 of the first detection connection line 321 located in the second source-drain metal layer and the first data leading-out line 3231 located in the first gate metal layer; and an interlayer dielectric layer 103, a shielding electrode 351, and a first planarization layer 105 may be provided between the second extension segment 3212 of the first detection connection line 321 located in the second source-drain metal layer and the second data leading-out line 3232 located in the second gate metal layer. At least a shielding electrode 351 and two insulation layers (including an interlayer dielectric layer 103 and a first planarization layer 105) are provided between the data leading-out line and the second extension segment 3212 of the first detection connection line 321. Rest of description of the present example may be referred to description of the aforementioned embodiments, and thus will not be repeated here.

FIG. 8 is a partial schematic diagram of a second bezel region according to at least one embodiment of the present disclosure. In FIG. 8, connections and positional relationships among a first set of data fanout lines, a first set of data bending lines, a first set of data leading-out lines, and parts of line segments of a first detection connection line and a second detection connection line are illustrated.

In some examples, as shown in FIG. 8, the first set of data fanout lines may include a plurality of first data fanout lines 3131 located in the first gate metal layer and a plurality of second data fanout lines 3132 located in the second gate metal layer. The plurality of first data fanout lines 3131 and the plurality of second data fanout lines 3132 may be disposed at intervals along the first direction X, and orthographic projections of the first data fanout lines 3131 on the base substrate may not be overlapped with orthographic projections of the second data fanout lines 3132 on the base substrate. In other words, a distance between orthographic projections of a first data fanout line 3131 and a second data fanout line 3132 which are adjacent on the base substrate is greater than 0. The first data fanout line 3131 and the second data fanout line 3132 may be connected with a data bending line 333 located in the second source-drain metal layer, respectively.

In some examples, the first set of data leading-out lines may include a plurality of first data leading-out lines 3231 located in the first gate metal layer and a plurality of second data leading-out lines 3232 located in the second gate metal layer. The first data leading-out line 3231 and the second data leading-out line 3232 may be connected with the data bending line 333 located in the second source-drain metal layer, respectively. The data bending line 333 may be connected with a corresponding data leading-out line and data fanout line to achieve transmission of a data signal.

In some examples, the first end 3111 of the first crack detection line 311 may be located in the first gate metal layer and connected with the first detection bending line 331a located in the second source-drain metal layer. The first detection bending line 331a may also be connected with the first extension segment 3211 of the first detection connection line 321 located in the first gate metal layer. The first extension segment 3211 may be connected with the second extension segment 3212 located in the second source-drain metal layer. The second extension segment 3212 may be connected with the third extension segment 3213 located in the first gate metal layer. The third extension segment 3213 may be connected with the first detection bending line 331b located in the second source-drain metal layer. The first detection bending line 331b may be connected with the first end 3121 of the second crack detection line 312 located in the first touch conductive layer.

In some examples, the touch fanout line 315 located in the first touch conductive layer may be connected with the touch bending line 335 located in the second source-drain metal layer. The touch bending line 335 may be connected with the touch leading-out line 325 located in the first touch conductive layer.

In some examples, the first power supply transmission line 316 located in the first source-drain metal layer may be connected with the first power supply bending line (e.g., the first power supply bending line 336a) located in the second source-drain metal layer, and the first power supply bending line 336a and the second sub-electrical power supply line of the first electrical power supply line 326 located in the second source-drain metal layer may be of an interconnected integral structure. The shielding electrode 351 and the first sub-electrical power supply line of the first electrical power supply line 326 located in the first source-drain metal layer may be of an interconnected integral structure.

In some examples, the first transfer region D1 is a transfer region between the first end 3121 of the second crack detection line 312 located in the first touch conductive layer and the first detection bending line 331b located in the second source-drain metal layer. The second transfer region D2 is a transfer region between the first detection bending line 331b located in the second source-drain metal layer and the third extension segment 3213 of the first detection connection line 321 located in the first gate metal layer. The third transfer region D3 is a transfer region between the third extension segment 3213 of the first detection connection line 321 located in the first gate metal layer and the second extension segment 3212 located in the second source-drain metal layer. The fourth transfer region D4 is a transfer region between the first extension segment 3211 of the first detection connection line 321 located in the first gate metal layer and the second extension segment 3212 located in the second source-drain metal layer. The fifth transfer region D5 is a transfer region between the first extension segment 3211 of the first detection connection line 321 located in the first gate metal layer and the first detection bending line 331a located in the second source-drain metal layer. The sixth transfer region D6 is a transfer region between the first end 3111 of the first crack detection line 311 located in the first gate metal layer and the first detection bending line 331a located in the second source-drain metal layer. The seventh transfer region D7 is a transfer region between a portion located in the first gate metal layer and a portion located in the second source-drain metal layer of the fifth extension segment 3222 of the second detection connection line 322a.

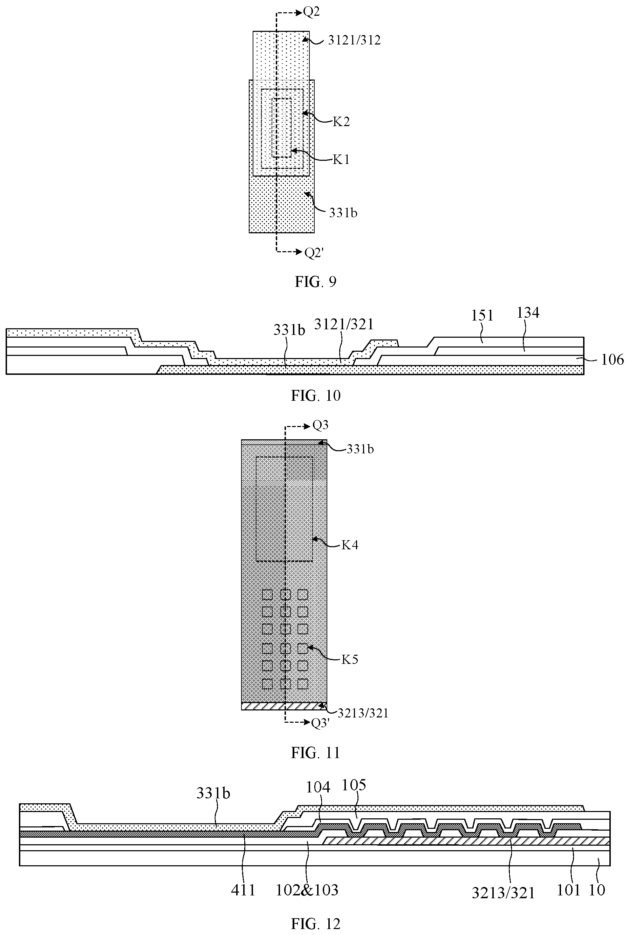

FIG. 9 is a partially enlarged schematic view of a first transfer region D1 in FIG. 8. FIG. 10 is a schematic partial cross-sectional view along a direction Q2-Q2' in FIG. 9. A film layer on a side of the second source-drain metal layer close to the base substrate is omitted in FIG. 10. In some examples, at least parts of the first gate insulation layer 101, the second gate insulation layer 102, the interlayer dielectric layer 103, the passivation layer 104, and the first planarization layer 105 of the bending region B22 may be removed to reduce a thickness of the bending region and facilitate bending.

In some examples, as shown in FIGs. 8 to 10, an orthographic projection of the first end 3121 of the second crack detection line 312 on the base substrate may be partially overlapped with an orthographic projection of the first detection bending line 331b on the base substrate. The first detection bending line 331b located in the second source-drain metal layer may be connected with the first end 3121 of the second crack detection line 312 located in the first touch conductive layer through a first via K1 opened in the second planarization layer 106, a third via opened in the pixel definition layer 134, and a second via K2 opened in a touch buffer layer 151. The second planarization layer 106, the pixel definition layer 314, and the touch buffer layer 151 may be disposed sequentially along a direction away from the base substrate.

FIG. 11 is a partially enlarged schematic view of a second transfer region D2 in FIG. 8. FIG. 12 is a schematic partial cross-sectional view along a direction Q3-Q3' in FIG. 11. In some examples, as shown in FIGs. 8, 11, and 12, the first detection bending line 331b located in the second source-drain metal layer may be connected with the first connection electrode 411 located in the first source-drain metal layer through a fourth via K4 opened in the first planarization layer 105 and the passivation layer 104. The first connection electrode 411 may be connected with the third extension segment 3213 of the first detection connection line 321 located in the first gate metal layer through a plurality of fifth vias K5 opened in the interlayer dielectric layer 103 and the second gate insulation layer 102. The plurality of fifth vias K5 may be arranged in an array, which may be arranged, for example, in six rows and three columns. An orthographic projection of the first connection electrode 411 on the base substrate may be partially overlapped with orthographic projections of the first detection bending line 331b and the third extension segment 3213 on the base substrate, and an orthographic projection of the first detection bending line 331b may be partially overlapped with an orthographic projection of the third extension segment 3213 on the base substrate.

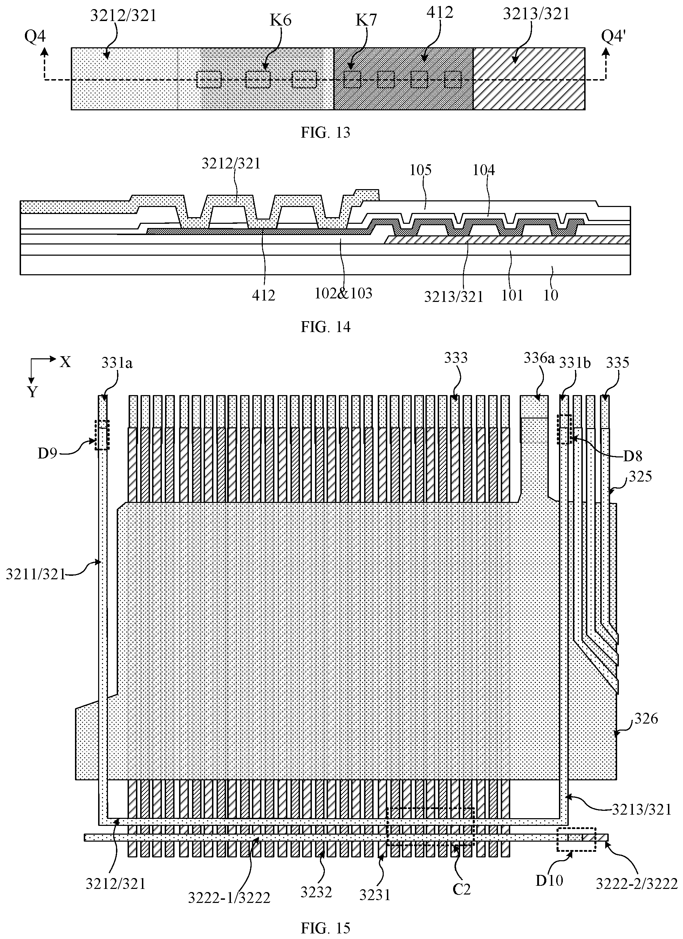

FIG. 13 is a partially enlarged schematic view of a third transfer region D3 in FIG. 8. FIG. 14 is a schematic partial cross-sectional view along a direction Q4-Q4' in FIG. 13. In some examples, as shown in FIGs. 8, 13, and 14, the second extension segment 3212 of the first detection connection line 321 located in the second source-drain metal layer may be connected with a second connection electrode 412 located in the first source-drain metal layer through a plurality of (e.g., three) sixth vias K6 opened in the first planarization layer 105 and the passivation layer 104. The second connection electrode 412 may be connected with the third extension segment 3213 of the first detection connection line 321 located in the first gate metal layer through a plurality of (e.g., three) seventh vias K7 opened in the interlayer dielectric layer 103 and the second gate insulation layer 102. An orthographic projection of the first connection electrode 412 on the base substrate may be partially overlapped with orthographic projections of the second extension segment 3212 and the third extension segment 3213 on the base substrate, and an orthographic projection of the second extension segment 3212 on the base substrate may not be overlapped with an orthographic projection of the third extension segment 3213 on the base substrate. However, the present embodiment is not limited thereto. In other examples, orthographic projections of the second extension segment and the third extension segment on the base substrate may partially be overlapped.

In some examples, a transfer mode between traces located in the second source-drain metal layer and traces located in the first gate metal layer in the fourth transfer region D4, the fifth transfer region D5, the sixth transfer region D6, and the seventh transfer region D7 is similar to a transfer mode of the third transfer region D3, and thus will not be repeated here.

In this example, an interlayer dielectric layer, a passivation layer, and a first planarization layer are provided (or an interlayer dielectric layer and a first planarization layer are provided) between a detection connection line and a data leading-out line, so that a minimum thickness between the detection connection line and a data leading-out line of which an orthographic projection is overlapped with an orthographic projection of the detection connection line may be increased, and a coupling capacitance between the detection connection line and the data leading-out line may be reduced. In addition, a shielding electrode is provided between the detection connection line and the data leading-out line, and the shielding electrode and the first sub-electrical power supply line of the first electrical power supply line are of an interconnected integral structure, so that the shielding electrode may be used to shield the data leading-out line of which an orthographic projection is overlapped with an orthographic projection of the detection connection line, and a coupling capacitance between the detection connection line and the data leading-out line may be reduced, thereby reducing an influence of the detection connection line on a data signal, and reducing a risk of poor display of the display panel.

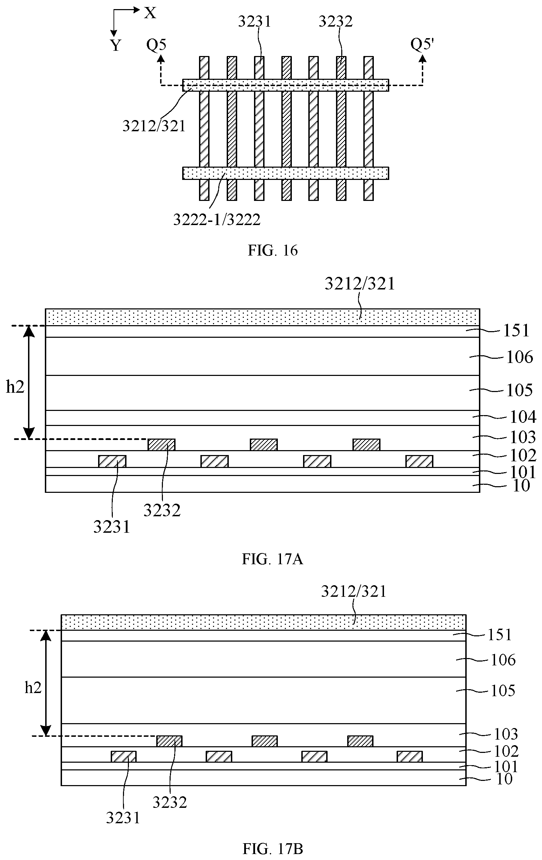

FIG. 15 is a partial schematic diagram of a second bezel region according to at least one embodiment of the present disclosure. In FIG. 15, a schematic diagram of a partial structure of the bending region and the second fanout region is illustrated. FIG. 16 is a partially enlarged schematic view of a region C2 in FIG. 15. FIG. 17A is a schematic partial cross-sectional view along a direction Q5-Q5' in FIG. 16. FIG. 17B is another schematic partial cross-sectional view along a Q5-Q5' direction in FIG. 16.

In some examples, as shown in FIGs. 15 to 17A, the first extension segment 3211, the second extension segment 3212, and the third extension segment 3213 of the first detection connection line 321 may be of an interconnected integral structure. An orthographic projection of the first detection connection line 321 on the base substrate may be overlapped with orthographic projections of a plurality of data leading-out lines (a first set of data leading-out lines including a plurality of first data leading-out lines 3231 located in the first gate metal layer and a plurality of second data leading-out lines 3232 located in the second gate metal layer) on the base substrate. An orthographic projection of the fifth extension segment 3222 of the second detection connection line 322a on the base substrate may be overlapped with orthographic projections of a plurality of data leading-out lines (including the first set of data leading-out lines) on the base substrate. The first detection connection line 321 and the fifth extension segment 3222 of the second detection connection line 322a may be located in the first touch conductive layer.

In some examples, as shown in FIG. 17A, an interlayer dielectric layer 103, a passivation layer 104, a first planarization layer 105, a second planarization layer 106, and a touch buffer layer 151 may be provided between the second extension segment 3212 located in the first touch conductive layer and the data leading-out line 3232 located in the second gate metal layer. A second gate insulation layer 102, an interlayer dielectric layer 103, a passivation layer 104, a first planarization layer 105, a second planarization layer 106, and a touch buffer layer 151 may be provided between the second extension segment 3212 located in the first touch conductive layer and the data leading-out line 3231 located in the first gate metal layer. At least five insulation layers are provided between the data leading-out line and the second extension segment 3212 of the first detection connection line 321, wherein inorganic insulation layers may include an interlayer dielectric layer 103, a passivation layer 104, and a touch buffer layer 151, and organic insulation layers may include a first planarization layer 105 and a second planarization layer 106. In some examples, a minimum thickness h2 between the second extension segment 3212 of the first detection connection line 321 and the data leading-out line may include a sum of thicknesses of the interlayer dielectric layer 103, the passivation layer 104, the first planarization layer 105, the second planarization layer 106, and the touch buffer layer 151. However, the present embodiment is not limited thereto.

In other examples, as shown in FIG. 17B, an interlayer dielectric layer 103, a first planarization layer 105, a second planarization layer 106, and a touch buffer layer 151 may be provided between the second extension segment 3212 located in the first touch conductive layer and the data leading-out line 3232 located in the second gate metal layer. A second gate insulation layer 102, an interlayer dielectric layer 103, a first planarization layer 105, a second planarization layer 106, and a touch buffer layer 151 may be provided between the second extension segment 3212 located in the first touch conductive layer and the data leading-out line 3231 located in the first gate metal layer. At least four insulation layers are provided between the data leading-out line and the second extension segment 3212 of the first detection connection line 321, wherein inorganic insulation layers may include an interlayer dielectric layer 103, and a touch buffer layer 151, and organic insulation layers may include a first planarization layer 105 and a second planarization layer 106. However, the present embodiment is not limited thereto. In other examples, the first planarization layer may be omitted on ae basis of ensuring that a minimum thickness between the data leading-out line and the first detection connection line is greater than 2.1 microns. In other examples, the display structure layer of the display panel may also include a third source-drain metal layer and a third planarization layer located on a side of the second source-drain metal layer away from the base substrate, and at least five insulation layers may be provided between the data leading-out line and the second extension segment 3212 of the first detection connection line 321 located in the first touch conductive layer, wherein inorganic insulation layers may include an interlayer dielectric layer and a touch buffer layer, and organic insulation layers may include a first planarization layer, a second planarization layer, and a third planarization layer.

In some examples, the first touch conductive layer may be of a stacked structure of three layers of metal, which may be, for example, a three-layer stacked structure of titanium aluminum titanium (Ti/Al/Ti). A thickness of the interlayer dielectric layer 103 may be 0.045 micron to 0.055 micron, which may be, for example, about 0.05 micron; a thickness of the passivation layer 104 may be 0.025 micron to 0.033 micron, which may be, for example, about 0.03 micron; a thickness of the first planarization layer 105 may be 1.35 microns to 1.65 microns, which may be, for example, about 1.5 microns; a thickness of the second planarization layer 106 may be 1.35 microns to 1.65 microns, which may be, for example, about 1.5 microns; and a thickness of the touch buffer layer 151 may be 0.025 micron to 0.033 micron, which may be, for example, about 0.03 micron.

In some examples, the fifth extension segment 3222 of the second detection connection line 322a is similar to a film layer structure between data leading-out lines, and thus will not be repeated here.

In this example, the first detection connection line and the fifth extension segment of the second detection connection line are provided in the first touch conductive layer, so that a minimum thickness between a detection connection line and a data leading-out line of which an orthographic projection is overlapped with an orthographic projection of the detection connection line may be increased, and a coupling capacitance between the detection connection line and the data leading-out line may be reduced. Moreover, since a quantity of insulation layers between the detection connection line and the data leading-out line of which the orthographic projection is overlapped with the orthographic projection of the detection connection line in this example is relatively large and a total thickness of the insulation layers is relatively large, a shielding electrode may not be provided, and a coupling capacitance between the detection connection line and the data leading-out line is reduced only by increasing a distance between the detection connection line and the data leading-out line of which the orthographic projection is overlapped with the orthographic projection of the detection connection line.

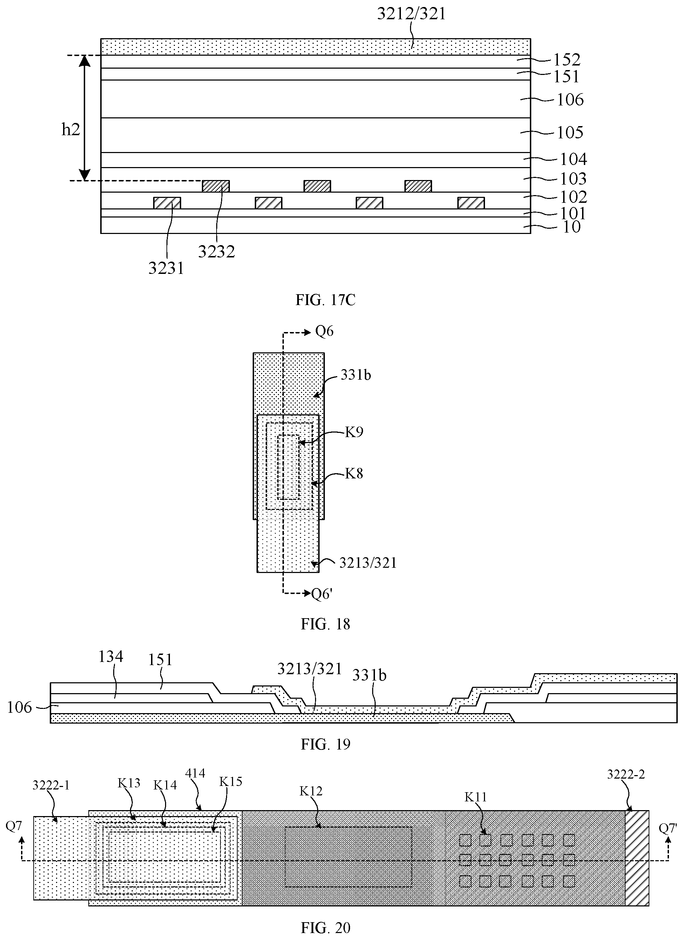

FIG. 17C is another schematic partial cross-sectional view along a Q5-Q5' direction in FIG. 16. In some examples, as shown in FIG. 17C, the first detection connection line 321 and the fifth extension segment 3222 of the second detection connection line 322a may be located in the second touch conductive layer. In the present example, at least six insulation layers (including an interlayer dielectric layer 103, a passivation layer 104, a first planarization layer 105, a second planarization layer 106, a touch buffer layer 151, and a touch insulation layer 152) are provided between a data leading-out line and the second extension segment 3212 of the first detection connection line 321. In this example, the first detection connection line and the fifth extension segment of the second detection connection line are provided in the second touch conductive layer, so that a minimum thickness between the detection connection line and a data leading-out line of which an orthographic projection is overlapped with an orthographic projection of the detection connection line may be increased, and a coupling capacitance between the detection connection line and the data leading-out line may be reduced. However, the present embodiment is not limited thereto. In other examples, the first detection connection line 321 and the fifth extension segment 3222 of the second detection connection line 322a may be located in different conductive layers; for example, the first detection connection line 321 may be located in the first touch conductive layer, and the fifth extension segment 3222 of the second detection connection line 322a may be located in the second touch conductive layer; or the first detection connection line 321 may be located in the second touch conductive layer, and the fifth extension segment 3222 of the second detection connection line 322a may be located in the first touch conductive layer. Rest of a structure of the display panel of the example may be referred to description of the aforementioned embodiments, and thus will not be repeated here.

FIG. 18 is a partially enlarged schematic view of an eighth transfer region D8 in FIG. 15. FIG. 19 is a schematic partial cross-sectional view along a direction Q6-Q6' in FIG. 18. A film layer on a side of the second source-drain metal layer close to the base substrate is omitted in FIG. 19. In some examples, at least parts of the first gate insulation layer 101, the second gate insulation layer 102, the interlayer dielectric layer 103, the passivation layer 104, and the first planarization layer 105 of the bending region B22 may be removed to reduce a thickness of the bending region and facilitate bending.

In some examples, as shown in FIGs. 15, 18, and 19, the third extension segment 3213 of the first detection connection line 321 located in the first touch conductive layer may be connected with the first detection bending line 331b located in the second source-drain metal layer through an eighth via K8 opened in the second planarization layer 106, a tenth via K9 opened in the pixel definition layer 134, and a ninth via K9 opened in the touch buffer layer 151. The second planarization layer 106, the pixel definition layer 314, and the touch buffer layer 151 may be disposed sequentially along a direction away from the base substrate.

In some examples, a transfer mode between traces located in the first touch conductive layer and traces located in the second source-drain metal layer in the ninth transfer region D9 is similar to a transfer mode of the eighth adapting region D8, thus will not be repeated here.

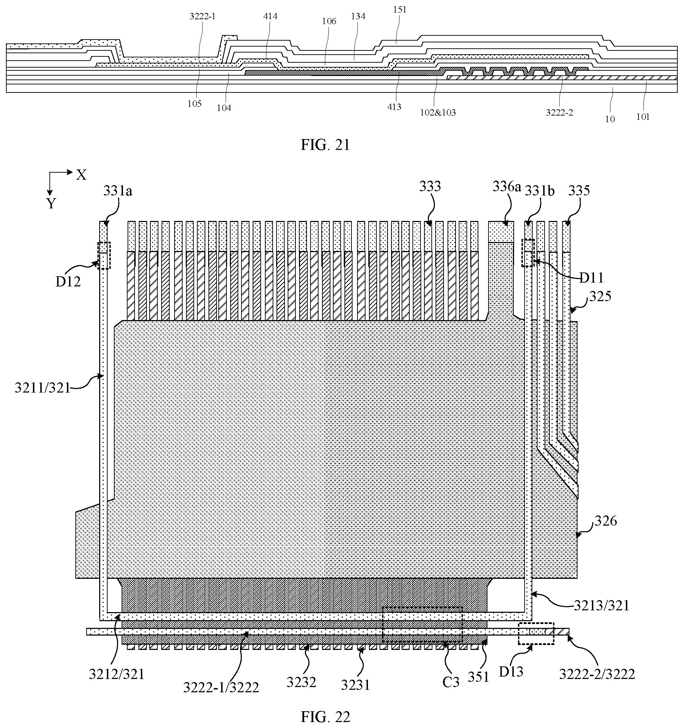

FIG. 20 is a partially enlarged schematic view of a tenth transfer region D10 in FIG. 15; FIG. 21 is a schematic partial cross-sectional view along a direction Q7-Q7' in FIG. 20. In some examples, as shown in FIGs. 15, 20, and 21, the fifth extension segment 3222 of the second detection connection line 322a may include a first line segment 3222-1 located in the first touch conductive layer and a second line segment 3222-2 located in the first gate metal layer. The first line segment 3222-1 and the second line segment 3222-2 are connected. An orthographic projection of the first line segment 3222-1 on the base substrate is overlapped with orthographic projections of the first set of data leading-out lines on the base substrate, and an orthographic projection of the second line segment 3222-2 on the base substrate may not be overlapped with orthographic projections of a plurality of data leading-out lines on the base substrate.

In some examples, the first line segment 3222-1 located in the first touch conductive layer may be connected with the fourth connection electrode 414 located in the second source-drain metal layer through a fifteenth via K15 opened in the touch buffer layer 151, a fourteenth via K14 opened in the pixel definition layer 134, and a thirteenth via K13 opened in the second planarization layer 106. The fourth connection electrode 414 may be connected with the third connection electrode 413 located in the first source-drain metal layer through a twelfth via K12 opened in the passivation layer 104 and the first planarization layer 105. The third connection electrode 413 may be connected with the second line segment 3222-2 located in the first gate metal layer through a plurality of eleventh vias K11 opened in the second gate insulation layer 102 and the interlayer dielectric layer 103. The plurality of eleventh vias K11 may be arranged in an array. Orthographic projections of the fourth connection electrode 414 and the third connection electrode 413 on the base substrate may be partially overlapped, for example, an orthographic projection of the fourth connection electrode 414 on the base substrate may cover an orthographic projection of the third connection electrode 413 on the base substrate. The orthographic projections of the fourth connection electrode 414 and the third connection electrode 413 on the base substrate may be partially overlapped with an orthographic projection of the second line segment 3222-2 on the base substrate, and the orthographic projections of the fourth connection electrode 414 on the base substrate may be partially overlapped with an orthographic projection of the first line segment 3222-1 on the base substrate. Orthographic projections of the first line segment 3222-1 and the second line segment 3222-2 on the base substrate may not be overlapped. The present embodiment is not limited thereto.

In the present example, an electrical connection between the first line segment and the second line segment of the fifth extension segment is achieved through the fourth connection electrode and the third connection electrode, so that effectiveness of the connection may be ensured, and an excessively deep via may be avoided.

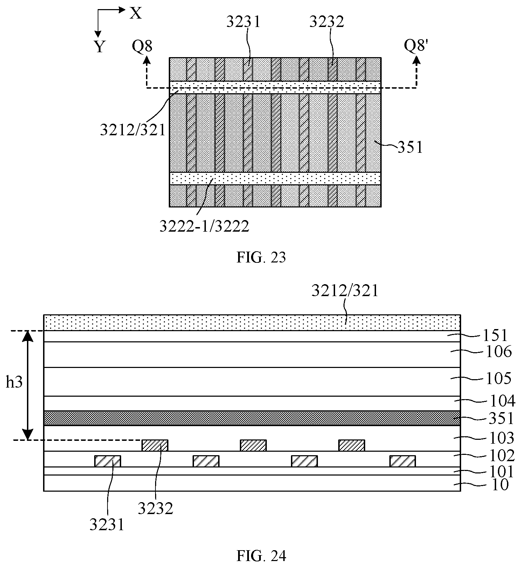

FIG. 22 is another partial schematic diagram of a second bezel region according to at least one embodiment of the present disclosure. In FIG. 22, a schematic diagram of a partial structure of the bending region and the second fanout region is illustrated. FIG. 23 is a partially enlarged schematic view of a region C3 in FIG. 22. FIG. 24 is a schematic partial cross-sectional view along a direction Q8-Q8' in FIG. 23.

In some examples, as shown in FIGs. 22 to 24, the first extension segment 3211, the second extension segment 3212, and the third extension segment 3213 of the first detection connection line 321 may be of an interconnected integral structure. The first detection connection line 321 and the fifth extension segment 3222 of the second detection connection line 322a may be located in the first touch conductive layer. A shielding electrode 351 is provided at a position where the second extension segment 3212 of the first detection connection line 321 and the fifth extension segment 3222 of the second detection connection line 322a cross a data leading-out line. The shielding electrode 351 may be located in the first source-drain metal layer, and has an interconnected integral structure with the first sub-electrical power supply line of the first electrical power supply line 326. An orthographic projection of the shielding electrode 351 on the base substrate may cover an overlapping portion of orthographic projections of the second extension segment 3212 of the first detection connection line 321 and the fifth extension segment 3222 of the second detection connection line 322a on the base substrate and an orthographic projection of the data leading-out line on the base substrate.

In some examples, as shown in FIG. 24, a minimum thickness h3 between the second extension segment 3212 of the first detection connection line 321 and the data leading-out line may include a sum of thicknesses of the interlayer dielectric layer 103, the shielding electrode 351, the passivation layer 104, the first planarization layer 105, the second planarization layer 106, and the touch buffer layer 151.

In this example, the first detection connection line and the fifth extension segment of the second detection connection line are provided in the first touch conductive layer, so that a minimum thickness between the detection connection line and the data leading-out line of which an orthographic projection is overlapped with an orthographic projection of the detection connection line may be increased, and a coupling capacitance between the detection connection line and the data leading-out line may be reduced. Moreover, by providing a shielding electrode that may be located in the first source-drain metal layer and separate the data leading-out line from the detection connection line, a coupling capacitance between the detection connection line and the data leading-out line may be further reduced.

In some examples, in an eleventh transfer region D11 and a twelfth transfer region D12, a transfer mode between traces located in the second source-drain metal layer and traces located in the first touch conductive layer may be referred to a transfer mode of the eighth adapting region D8, and in a thirteenth adapting region D13, a transfer mode between traces located in the first gate metal layer and traces located in the first touch conductive layer may be referred to a transfer mode of the tenth transfer region D10, and thus will not be repeated here.

Rest of the structure of the display panel of the example may be referred to description of the aforementioned embodiments, and thus will not be repeated here.

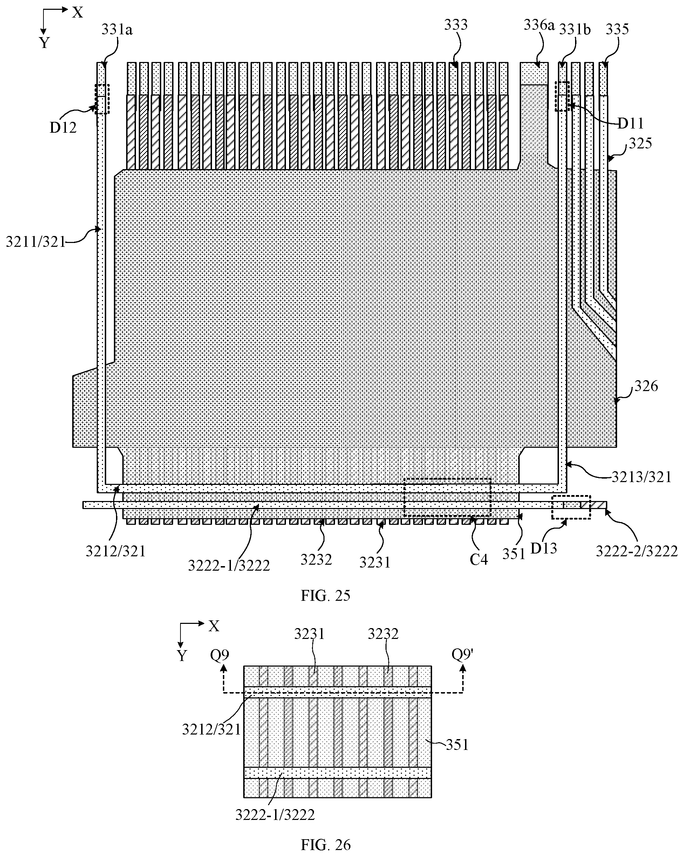

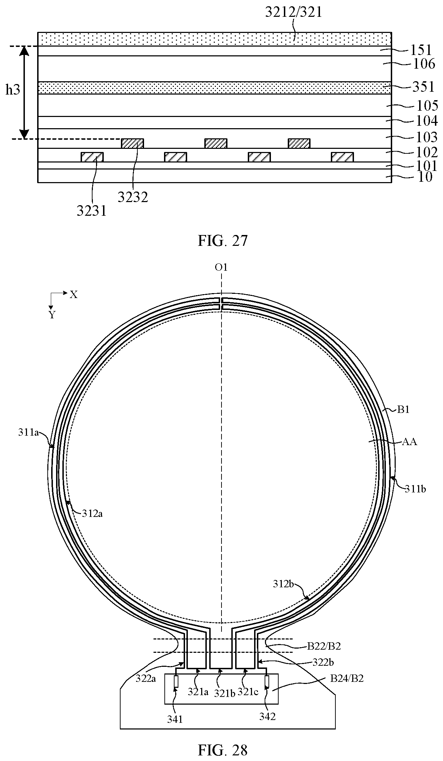

FIG. 25 is another partial schematic diagram of a second bezel region according to at least one embodiment of the present disclosure. In FIG. 25, a schematic diagram of a partial structure of the bending region and the second fanout region is illustrated. FIG. 26 is a partially enlarged schematic view of a region C4 in FIG. 25. FIG. 27 is a schematic partial cross-sectional view along a direction Q9-Q9' in FIG. 26.

In some examples, as shown in FIGs. 25 to 27, the first extension segment 3211, the second extension segment 3212, and the third extension segment 3213 of the first detection connection line 321 may be of an interconnected integral structure. The first detection connection line 321 and the fifth extension segment 3222 of the second detection connection line 322a may be located in the first touch conductive layer. A shielding electrode 351 is provided at a position where the second extension segment 3212 of the first detection connection line 321 and the fifth extension segment 3222 of the second detection connection line 322a cross a data leading-out line. The shielding electrode 351 may be located in the second source-drain metal layer, and has an interconnected integral structure with the second sub-electrical power supply line of the first electrical power supply line 326. An orthographic projection of the shielding electrode 351 on the base substrate may cover an overlapping portion of orthographic projections of the second extension segment 3212 of the first detection connection line 321 and the fifth extension segment 3222 of the second detection connection line 322a on the base substrate and an orthographic projection of the data leading-out line on the base substrate.

In some examples, as shown in FIG. 26, a minimum thickness h3 between the second extension segment 3212 of the first detection connection line 321 and the data leading-out line may include a sum of thicknesses of the interlayer dielectric layer 103, the passivation layer 104, the first planarization layer 105, the shielding electrode 351, the second planarization layer 106, and the touch buffer layer 151.

In this example, the first detection connection line and the fifth extension segment of the second detection connection line are provided in the first touch conductive layer, so that a minimum thickness between a detection connection line and a data leading-out line of which an orthographic projection is overlapped with an orthographic projection of the detection connection line may be increased, and a coupling capacitance between the detection connection line and the data leading-out line may be reduced. Moreover, by providing a shielding electrode that may be located in the second source-drain metal layer and separate the data leading-out line from the detection connection line, a coupling capacitance between the detection connection line and the data leading-out line may be further reduced.

Rest of the structure of the display panel of the example may be referred to description of the aforementioned embodiments, and thus will not be repeated here.

In other examples, the second extension segment of the first detection connection line and the fifth extension segment of the second detection connection line may be located in different conductive layers. For example, the second extension segment of the first detection connection line may be located in the second source-drain metal layer, the fifth extension segment of the second detection connection line may be located in the first touch conductive layer or the second touch conductive layer, and an orthographic projection of the shielding electrode on the base substrate may be overlapped with the second extension segment, but not overlapped with the fifth extension segment.

In other examples, the fifth extension segment of the second detection connection line may be located on a side of the second extension segment of the first detection connection line close to the bending region, and the first extension segment and the third extension segment of the first detection connection line may be located in different conductive layers from the fifth extension segment. An orthographic projection of the shielding electrode on the base substrate may be overlapped with an orthographic projection of the fifth extension segment on the base substrate, and is not overlapped with an orthographic projection of the second extension segment on the base substrate.

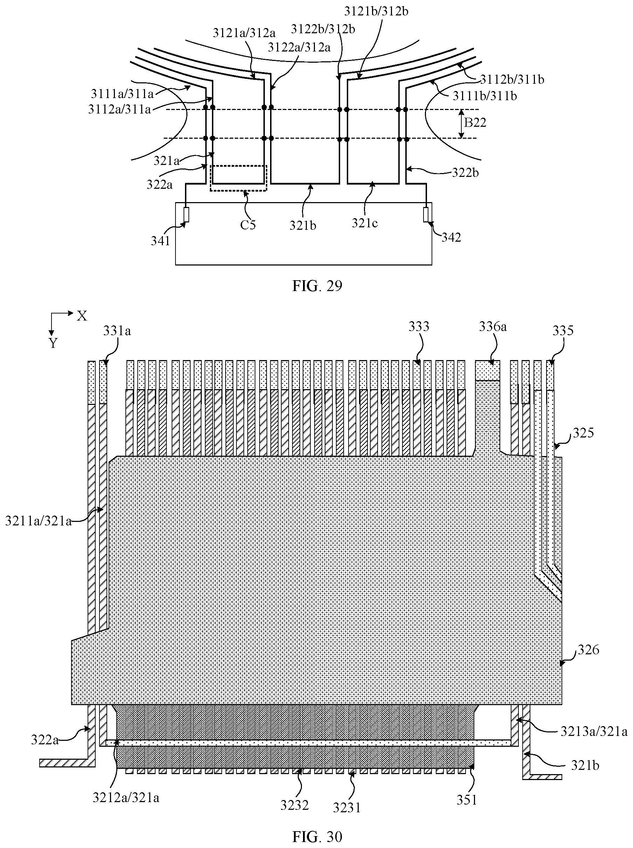

FIG. 28 is another schematic diagram of crack detection of a display panel according to at least one embodiment of the present disclosure. FIG. 29 is a partially enlarged schematic view of a second bezel region in FIG. 28. FIG. 30 is a schematic diagram of a structure of a partial film layer of a region C5 in FIG. 29.

In some examples, as shown in FIGs. 28 and 29, the display structure layer may include a plurality of first crack detection lines (e.g., including first crack detection lines 311a and 311b) at least located in the first bezel region B1; and the touch structure layer may include a plurality of second crack detection lines (including, for example, second crack detection lines 312a and 312b) at least located in the first bezel region B1. The first crack detection line 311a and the second crack detection line 312a may be wound on a left side of the display region AA, and the first crack detection line 311a may be located on a side of the second crack detection line 312a away from the display region AA. The first crack detection line 311b and the second crack detection line 312b may be wound on a right side of the display region AA, and the first crack detection line 311b may be located on a side of the second crack detection line 312b away from the display region AA.

In some examples, the first crack detection lines 311a and 311b may be disposed symmetrically with respect to a centerline O1 of the display panel in the first direction X, and the second crack detection lines 312a and 312b may be disposed symmetrically with respect to the centerline O1 of the display panel in the first direction X. in this example, a crack detection line mirror image design may be adopted.

In some examples, the plurality of detection connection lines of the second bezel region may include first detection connection lines 321a, 321b, and 321c, and second detection connection lines 322a and 322b. In this example, the first detection connection line achieves a connection in series between crack detection lines, and the second detection connection line achieves a connection in series between a crack detection line and a detection contact pad.

In some examples, one end of the second detection connection line 322a may be connected with the first end 3111a of the first crack detection line 311a through a detection bending line of the bending region B22, and the other end of the second detection connection line 322a may be connected with the first detection contact pad 341 within the first signal access region B24. One end of the first detection connection line 321a may be connected with the second end 3112a of the first crack detection line 311a through a detection bending line of the bending region B22, and the other end of the first detection connection line 321a may be connected with the first end 3121a of the second crack detection line 312a through a detection bending line of the bending region B22. One end of the first detection connection line 321b may be connected with the second end 3122a of the second crack detection line 312a through a detection bending line of the bending region B22, and the other end of the first detection connection line 321b may be connected with the second end 3122b of the second crack detection line 312b through a detection bending line of the bending region B22. One end of the first detection connection line 321c may be connected with the first end 3121b of the second crack detection line 312b through a detection bending line of the bending region B22, and the other end of the first detection connection line 321c may be connected with the second end 3112b of the first crack detection line 311b through a detection bending line of the bending region B22. One end of the second detection connection line 322b may be connected with the first end 3111b of the first crack detection line 311b through a detection bending line of the bending region B22, and the other end may be connected with the second detection contact pad 342 within the first signal access region B24.

In some examples, the second detection connection lines 322a and 322b may be disposed substantially symmetrically with respect to the centerline O1 along the first direction X, of the display panel. The first detection connection lines 321a and 321c may be disposed substantially symmetrically with respect to the centerline O1 along the first direction X, of the display panel. The first detection connection line 321b may be substantially symmetrical with respect to the centerline O1 along the first direction X, of the display panel.

In some examples, as shown in FIG. 30, the first detection connection line 321a may include a first extension segment 3211a, a second extension segment 3212a, and a third extension segment 3213a connected sequentially. An orthographic projection of the second extension segment 3212a on the base substrate may be overlapped with orthographic projections of the first set of data leading-out lines (including a plurality of first data leading-out lines 3231 located in the first gate metal layer and a plurality of second data leading-out lines 3232 located in the second gate metal layer) on the base substrate. The first extension segment 3211a and the third extension segment 3213a may be located in the first gate metal layer, and the second extension segment 3212a may be located in the second source-drain metal layer. A shielding electrode 351 may be provided at a position where the second extension segment 3212a crosses the first set of data leading-out lines. The shielding electrode 351 may be located in the first source-drain metal layer, and has an interconnected integral structure with the first sub-electrical power supply line of the first electrical power supply line. An orthographic projection of the shielding electrode 351 on the base substrate may cover an overlapping portion of an orthographic projection of the second extension segment 3212a and orthographic projections of the first set of data leading-out lines on the base substrate. However, the present embodiment is not limited thereto. In other examples, the second extension segment 3212a of the first detection connection line 321a may be located in the first touch conductive layer or the second touch conductive layer, and a shielding electrode may not be provided. In other examples, the second extension segment 3212a of the first detection connection line 321a may be located in the first touch conductive layer or the second touch conductive layer, and a corresponding shielding electrode may be provided.

In some examples, an orthographic projection of the first detection connection line 321c on the base substrate may be overlapped with orthographic projections of the second set of data leading-out lines on the base substrate. A shielding electrode may be provided between the first detection connection line 321c and the second set of data leading-out lines of which orthographic projections are overlapped with an orthographic projection of the first detection connection line 321c, and the shielding electrode and the first sub-electrical power supply line of the first electrical power supply line may be of an interconnected integral structure. A structure of the first detection connection line 321c is similar to that of the first detection connection line 321a, and thus will not be repeated here. However, the present embodiment is not limited thereto. In other examples, an extension segment of the first detection connection line 321c that is overlapped with the second set of data leading-out lines may be located in a different conductive layer from the second extension segment 3212a of the first detection connection line 321a, for example, an extension segment of the first detection connection line 321c that is overlapped with the second set of data leading-out lines may be located in the first touch conductive layer or the second touch conductive layer, and a corresponding shield electrode and the second sub-electrical power supply line of the first electrical power supply line may be of an interconnected integral structure.

In some examples, the first detection connection line 321b may be located between the first set of data leading-out lines and the second set of data leading-out lines, and an orthographic projection of the first detection connection line 321b on the base substrate may not be overlapped with orthographic projections of the first set of data leading-out lines and the second set of data leading-out lines on the base substrate. In other words, a distance between the orthographic projection of the first detection connection line 321b on the base substrate and the orthographic projections of the first set of data leading-out lines and the second set of data leading-out lines on the base substrate is greater than 0. For example, the first detection connection line 321b may be located in the first gate metal layer. However, the present embodiment is not limited thereto.

In some examples, the second detection connection line 322a may be located on a side of the first set of data leading-out lines in an opposite direction of the first direction X, and the second detection connection line 322b may be located on a side of the second set of data leading-out lines in the first direction X. Orthographic projections of the second detection connection lines 322a and 322b on the base substrate may not be overlapped with orthographic projections of a plurality of data leading-out lines on the base substrate. In other words, a distance between the orthographic projections of the second detection connection lines 322a and 322b on the base substrate and the orthographic projections of the plurality of data leading-out lines on the base substrate is greater than 0.

In some examples, an orthographic projection of each data leading-out line on the base substrate is overlapped with orthographic projections of a same number of detection connection lines on the base substrate. For example, as shown in FIG. 30, an orthographic projection of each data leading-out line in the first set of data leading-out lines on the base substrate is overlapped with an orthographic projection of the first detection connection line 321a on the base substrate, and an orthographic projection of each data leading-out line in the second set of data leading-out lines on the base substrate is overlapped with an orthographic projection of the first detection connection line 321c on the base substrate. According to an arrangement mode of the present example, consistency of coupling capacitances between the plurality of data leading-out lines and the detection connection lines may be maintained, thereby reducing poor display such as uneven brightness, and ensuring display quality.

Rest of description of the display panel of the example may be referred to description of the aforementioned embodiments, and thus will not be repeated here.

An embodiment also provides a display panel, including a base substrate, a display structure layer, a touch structure layer, and at least one shielding electrode which are disposed on the base substrate. The base substrate includes: a display region and a bezel region located at a periphery of the display region, and the bezel region includes: a second bezel region located on a side of the display region, and a first bezel region located on remaining sides of the display region. The display structure layer includes a plurality of sub-pixels and a plurality of data lines located in the display region, at least one first crack detection line located in the first bezel region, and a plurality of data leading-out lines located in the second bezel region. The plurality of data lines are connected with the plurality of sub-pixels and are configured to provide data signals to the plurality of sub-pixels. The plurality of data leading-out lines are configured to provide data signals to the plurality of data lines. The touch structure layer is located on a side of the display structure layer away from the base substrate, and the touch structure layer includes at least one second crack detection line located in the first bezel region. At least one first crack detection line and at least one second crack detection line are connected in series in the second bezel region through a plurality of detection connection lines. An orthographic projection of at least one of the plurality of detection connection lines on the base substrate is overlapped with an orthographic projection of at least one of the plurality of data leading-out lines on the base substrate. The at least one shielding electrode is located in the second bezel region. In a direction perpendicular to the display panel, the shielding electrode may be located between at least a part of line segments of at least one detection connection line and at least one data leading-out line. An orthographic projection of the shielding electrode on the base substrate is at least partially overlapped with orthographic projections of the at least one detection connection line and the at least one data leading-out line on the base substrate. For example, the orthographic projection of the shielding electrode on the base substrate may cover an overlapping portion of an orthographic projection of the at least one detection connection line on the base substrate and an orthographic projection of the at least one data leading-out line on the base substrate.

In the display panel according to the present embodiment, a shielding electrode is provided in the second bezel region, and the shielding electrode is used to separate a detection connection line from a data leading-out line, thereby reducing a coupling capacitance between the detection connection line and the data leading-out line, reducing interference of the coupling capacitance on a data signal, thus improving display quality of the display panel, and reducing a risk of poor display of the display panel.

In some exemplary implementation modes, at least two insulation layers may be provided between at least a part of line segments of at least one detection connection line and at least one data leading-out line, and the at least two insulation layers include at least one organic insulation layer and at least one inorganic insulation layer. In this example, at least two insulation layers are disposed between at least a part of line segments of a detection connection line and a data leading-out line of which an orthographic projection is overlapped with an orthographic projection of the detection connection line, which may increase a distance between the detection connection line and the data leading-out line of which the orthographic projection is overlapped with the orthographic projection of the detection connection line, thereby reducing a coupling capacitance between the detection connection line and the data leading-out line, reducing interference of the coupling capacitance on a data signal, thus improving display quality of the display panel, and reducing a risk of poor display of the display panel.

In some exemplary implementation modes, a minimum thickness between at least a part of line segments of at least one detection connection line and at least one data leading-out line may be greater than 2.1 microns. In this example, by setting a distance between a detection connection line and a data leading-out line of which an orthographic projection is overlapped with an orthographic projection of the detection connection line, a coupling capacitance between the detection connection line and the data leading-out line may be reduced, and interference of the coupling capacitance on a data signal may be reduced.

In some exemplary implementation modes, the display panel may further include a plurality of first power lines located in the display region and a first electrical power supply line located in the second bezel region, wherein the plurality of first power lines are electrically connected with the plurality of sub-pixels and the plurality of first power lines are connected with the first electrical power supply line, and the at least one shielding electrode is connected with the first electrical power supply line. In this example, the shielding electrode is provided to be connected with the first electrical power supply line, which is beneficial to achieve a shielding effect of the shielding electrode.

In some exemplary implementation modes, the first electrical power supply line includes a first sub-electrical power supply line and a second sub-electrical power supply line connected with each other, and the first sub-electrical power supply line is located on a side of the second sub-electrical power supply line close to the base substrate; and the at least one shielding electrode and the first sub-electrical power supply line are of an interconnected integral structure, or the at least one shielding electrode and the second sub-electrical power supply line are of an interconnected integral structure. In this example, the first electrical power supply line is disposed to have a double-layer trace structure, which is beneficial to reduce a impedance of the first electrical power supply line; and moreover, the shielding electrode and one layer of trace of the first electrical power supply line are of an interconnected integral structure, which is beneficial to an arrangement of shielding electrodes and reduces openings required for connections of the shielding electrodes and the first electrical power supply line.

In some exemplary implementation modes, the touch structure layer may include at least one touch conductive layer, and at least a part of line segments of at least one detection connection line may be located in a touch conductive layer of the touch structure layer. In this example, the detection connection line is disposed to be located in the touch conductive layer, a distance between the detection connection line and a data leading-out line of which an orthographic projection is overlapped with an orthographic projection of the detection connection line may be increased, thereby reducing a coupling capacitance between the detection connection line and the data leading-out line, and reducing interference of the coupling capacitance on a data signal.

Rest of description of the display panel of the example may be referred to description of the aforementioned embodiments, and thus will not be repeated here.

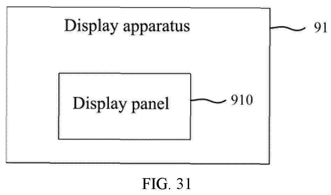

FIG. 31 is a schematic diagram of a display apparatus according to at least one embodiment of the present disclosure. As shown in FIG. 31, the present embodiment provides a display apparatus 91 including a display panel 910 of the aforementioned embodiments. In some examples, the display panel 910 may be a flexible OLED display substrate, a QLED display substrate, a Micro-LED display substrate, or a Mini-LED display substrate. The display apparatus may be a product having an image (including a still image or a moving image, wherein the moving image may be a video) display function. For example, the display apparatus may be: a display, a television, a billboard, a digital photo frame, a laser printer with a display function, a telephone, a mobile phone, a picture screen, a Personal Digital Assistant (PDA), a digital camera, a portable camcorder, a viewfinder, a navigator, a vehicle, a large-area wall, information inquiry equipment (such as business inquiry equipment in e-government, banks, hospitals, power departments, etc.), a monitor, etc. For another example, the display apparatus may be any one of a micro-display, a Virtual Reality (VR) device or an Augmented Reality (AR) device including a micro-display, etc.

The drawings of the present disclosure only involve structures involved in the present disclosure, and other structures may be referred to conventional designs. The embodiments of the present disclosure, i.e., features in the embodiments, may be combined with each other to obtain new embodiments if there is no conflict. It should be noted that the above embodiments or implementation mode are exemplary only and not restrictive. Therefore, the present disclosure is not limited to what is specifically shown and described herein. Various modifications, substitutions, or omissions may be made in forms and details of implementation without departing from the scope of the present disclosure.

## Claims

1. A display panel, comprising:
a base substrate, which comprises a display region and a bezel region located at a periphery of the display region, wherein the bezel region comprises: a second bezel region located on a side of the display region, and a first bezel region located on remaining sides of the display region;
a display structure layer disposed on the base substrate, which comprises: a plurality of sub-pixels and a plurality of data lines located in the display region, at least one first crack detection line located in the first bezel region, and a plurality of data leading-out lines located in the second bezel region, wherein the plurality of data lines are connected with the plurality of sub-pixels and configured to provide data signals to the plurality of sub-pixels, and the plurality of data leading-out lines are configured to provide data signals to the plurality of data lines; and
a touch structure layer located on a side of the display structure layer away from the base substrate, which comprises at least one second crack detection line located in the first bezel region, wherein the at least one first crack detection line and the at least one second crack detection line are connected in series in the second bezel region through a plurality of detection connection lines, an orthographic projection of at least one of the plurality of detection connection lines on the base substrate is overlapped with an orthographic projection of at least one of the plurality of data leading-out lines on the base substrate, and at least two insulation layers are provided between at least a part of line segments of the at least one detection connection line and the at least one data leading-out line.

2. The display panel according to claim 1, wherein the at least two insulation layers comprise at least one organic insulation layer and at least one inorganic insulation layer.

3. The display panel according to claim 1, wherein a minimum thickness between at least a part of line segments of the at least one detection connection line and the at least one data leading-out line is greater than 2.1 microns.

4. The display panel according to any one of claims 1 to 3, further comprising: at least one shielding electrode located in the second bezel region; in a direction perpendicular to the display panel, the shielding electrode is located between at least a part of line segments of the at least one detection connection line and the at least one data leading-out line; and an orthographic projection of the shielding electrode on the base substrate covers an overlapping portion of an orthographic projection of the at least one detection connection line on the base substrate and an orthographic projection of the at least one data leading-out line on the base substrate.

5. The display panel according to claim 4, further comprising: a plurality of first power lines located in the display region and a first electrical power supply line located in the second bezel region, wherein the plurality of first power lines are electrically connected with the plurality of sub-pixels and are connected with the first electrical power supply line, and the at least one shielding electrode is connected with the first electrical power supply line.

6. The display panel according to claim 5, wherein the first electrical power supply line comprises: a first sub-electrical power supply line and a second sub-electrical power supply line connected with each other, and the first sub-electrical power supply line is located on a side of the second sub-electrical power supply line close to the base substrate; and the at least one shielding electrode and the first sub-electrical power supply line are of an interconnected integral structure.

7. The display panel according to claim 6, wherein at least a part of line segments of the at least one detection connection line and the second sub-electrical power supply line are of a same layer structure.

8. The display panel according to claim 5, wherein the first electrical power supply line comprises a first sub-electrical power supply line and a second sub-electrical power supply line connected with each other, and the first sub-electrical power supply line is located on a side of the second sub-electrical power supply line close to the base substrate; the at least one shielding electrode and the second sub-electrical power supply line are of an interconnected integral structure; and at least a part of line segments of the at least one detection connection line is located on a side of the second sub-electrical power supply line away from the base substrate.

9. The display panel according to claim 4, wherein the display structure layer at least comprises: a first gate metal layer, a second gate metal layer, a first source-drain metal layer, and a second source-drain metal layer which are disposed on the base substrate; an interlayer dielectric layer is provided between the second gate metal layer and the first source-drain metal layer, and at least a first planarization layer is provided between the first source-drain metal layer and the second source-drain metal layer; at least a part of line segments of the at least one detection connection line is located in the second source-drain metal layer, and the shielding electrode is located in the first source-drain metal layer; the insulation layer between at least a part of line segments of the at least one detection connection line and the at least one data leading-out line at least comprises: the interlayer dielectric layer and the first planarization layer.

10. The display panel according to claim 9, wherein the plurality of data leading-out lines comprise a plurality of first data leading-out lines located in the first gate metal layer and a plurality of second data leading-out lines located in the second gate metal layer, and the plurality of first data leading-out lines and the plurality of second data leading-out lines are alternately disposed.

11. The display panel according to any one of claims 1 to 5, wherein the touch structure layer comprises at least one touch conductive layer, and at least a part of line segments of the at least one detection connection line is located in a touch conductive layer of the touch structure layer.

12. The display panel according to claim 1, wherein the second bezel region comprises a first signal access region, the first signal access region comprises a plurality of data contact pads, at least one first detection contact pad, and at least one second detection contact pad; the at least one first detection contact pad and the at least one second detection contact pad are located on both sides of the plurality of data contact pads along a first direction; the plurality of data contact pads are connected with the plurality of data leading-out lines; the plurality of detection connection lines comprise: two second detection connection lines and at least one first detection connection line; the first detection connection line is connected in series with the first crack detection line and the second crack detection line; one end of the first crack detection line and the second crack detection line connected in series is connected with the at least one first detection contact pad through one second detection connection line, and the other end is connected with the at least one second detection contact pad through the other second detection connection line; and an orthographic projection of a part of line segments of the at least one first detection connection line on the base substrate is partially overlapped with an orthographic projection of the at least one data leading-out line on the base substrate.

13. The display panel according to claim 12, wherein in the two second detection connection lines, an orthographic projection of one second detection connection line on the base substrate is partially overlapped with the orthographic projection of the at least one data leading-out line on the base substrate; and a distance between an orthographic projection of the other second detection connection line on the base substrate and orthographic projections of the plurality of data leading-out lines on the base substrate is greater than 0.

14. The display panel according to claim 13, wherein a part of line segments of the first detection connection line whose orthographic projection is overlapped with an orthographic projection of the at least one data leading-out line on the base substrate, and a part of line segments of the second detection connection line whose orthographic projection is overlapped with the orthographic projection of the at least one data leading-out line on the base substrate are of a same layer structure.

15. The display panel according to claim 12, wherein a distance between orthographic projections of the two second detection connection lines on the base substrate and orthographic projections of the plurality of data leading-out lines on the base substrate is greater than 0.

16. The display panel according to claim 12, wherein the at least one first detection connection line comprises: a first extension segment, a second extension segment, and a third extension segment connected sequentially; and an extension direction of the second extension segment intersects with an extension direction of the first extension segment and an extension direction of the third extension segment, an orthographic projection of the second extension segment on the base substrate is overlapped with the orthographic projection of the at least one data leading-out line on the base substrate, and a distance between orthographic projections of the first extension segment and the third extension segment on the base substrate and orthographic projections of the plurality of data leading-out lines on the base substrate is greater than 0.

17. The display panel according to claim 16, wherein the second extension segment is located on a side of the first extension segment and the third extension segment away from the base substrate, and the second extension segment is connected with the first extension segment or the third extension segment through a second connection electrode.

18. The display panel according to claim 16, wherein the first extension segment, the second extension segment, and the third extension segment of the first detection connection line are of an interconnected integral structure.

19. The display panel according to claim 1, wherein the display structure layer comprises a plurality of first crack detection lines, the plurality of first crack detection lines are symmetrically disposed with respect to a centerline of the display panel in a first direction; and the touch structure layer comprises a plurality of second crack detection lines, and the plurality of second crack detection lines are symmetrically disposed with respect to the centerline of the display panel in the first direction.

20. The display panel according to claim 19, wherein an orthographic projection of each data leading-out line located in the second bezel region on the base substrate is overlapped with orthographic projections of a same number of detection connection lines on the base substrate.

21. The display panel according to claim 19, wherein the plurality of detection connection lines in the second bezel region are symmetrically disposed with respect to the centerline of the display panel in the first direction.

22. The display panel according to claim 1, wherein the second bezel region further comprises a bending region, the bending region comprises: a plurality of detection bending lines; the plurality of detection connection lines are connected with the at least one first crack detection line and the at least one second crack detection line through the plurality of detection bending lines; and the plurality of detection bending lines are of a same layer structure.

23. A display apparatus, comprising a display panel according to any one of claims 1 to 22.

24. A display panel, comprising:
a base substrate, which comprises a display region and a bezel region located at a periphery of the display region, wherein the bezel region comprises: a second bezel region located on a side of the display region, and a first bezel region located on remaining sides of the display region;
a display structure layer disposed on the base substrate, which comprises: a plurality of sub-pixels and a plurality of data lines located in the display region, at least one first crack detection line located in the first bezel region, and a plurality of data leading-out lines located in the second bezel region, wherein the plurality of data lines are connected with the plurality of sub-pixels and configured to provide data signals to the plurality of sub-pixels, and the plurality of data leading-out lines are configured to provide data signals to the plurality of data lines;
a touch structure layer located on a side of the display structure layer away from the base substrate, which comprises at least one second crack detection line located in the first bezel region, wherein the at least one first crack detection line and the at least one second crack detection line are connected in series in the second bezel region through a plurality of detection connection lines, and an orthographic projection of at least one of the plurality of detection connection lines on the base substrate is overlapped with an orthographic projection of at least one of the plurality of data leading-out lines on the base substrate; and
at least one shielding electrode located in the second bezel region, wherein in a direction perpendicular to the display panel, the shielding electrode is located between at least a part of line segments of the at least one detection connection line and the at least one data leading-out line, and an orthographic projection of the shielding electrode on the base substrate is at least partially overlapped with orthographic projections of the at least one detection connection line and the at least one data leading-out line on the base substrate.

25. The display panel according to claim 24, wherein at least two insulation layers are provided between at least a part of line segments of the at least one detection connection line and the at least one data leading-out line, and the at least two insulation layers comprise at least one organic insulation layer and at least one inorganic insulation layer.

26. The display panel according to claim 24, wherein a minimum thickness between at least a part of line segments of the at least one detection connection line and the at least one data leading-out line is greater than 2.1 microns.

27. The display panel according to claim 24, further comprising: a plurality of first power lines located in the display region and a first electrical power supply line located in the second bezel region, wherein the plurality of first power lines are electrically connected with the plurality of sub-pixels and are connected with the first electrical power supply line, and the at least one shielding electrode is connected with the first electrical power supply line.

28. The display panel according to claim 27, wherein the first electrical power supply line comprises: a first sub-electrical power supply line and a second sub-electrical power supply line connected with each other, and the first sub-electrical power supply line is located on a side of the second sub-electrical power supply line close to the base substrate; and the at least one shielding electrode and the first sub-electrical power supply line are of an interconnected integral structure, or the at least one shielding electrode and the second sub-electrical power supply line are of an interconnected integral structure.

29. The display panel according to any one of claims 24 to 28, wherein the touch structure layer comprises at least one touch conductive layer, and at least a part of line segments of the at least one detection connection line is located in a touch conductive layer of the touch structure layer.
